# EUROPEAN PATENT APPLICATION

(11) **EP 4 568 460 A1**
(43) Date of publication of application: **11.06.2025**
(21) Application number: 24216818.5
(22) Date of filing: 02.12.2024
(51) Int. Cl.: H10K 59/80, G02B 5/00, G02F 1/13, B60K 35/20

(54) **DISPLAY DEVICE INCLUDING A LIGHT CONTROL LAYER**

(30) Priority: 06.12.2023 KR 20230175657
(71) Applicant: Samsung Display Co., Ltd., Gyeonggi-Do (KR)
(72) Inventor: Sim, Junho, Yongin-si, Gyeonggi-Do (KR); Jung, Yang-Ho, Yongin-si, Gyeonggi-Do (KR)
(74) Representative: Gulde & Partner

(57) **Abstract**

A display device includes a display layer (D-EL), and a light control layer (OCL) overlapping a pattern layer (LCF), which includes a transmission portion (TMP) and a light blocking portion (BMP), which cross one another in a first direction perpendicular to a thickness direction (DR3). The light control layer (OCL) includes a lower light control layer disposed below the pattern layer (LCF) and including a first portion overlapping the transmission portion (TMP), and a second portion overlapping the light blocking portion (BMP) and including a material that is different from that of the first portion and/or an upper light control layer disposed above the pattern layer (LCF) and including a plurality of protrusions protruding (not shown) in a direction away from the pattern layer (LCF).

## Description

### TECHNICAL FIELD

The present disclosure relates to a display device, and more particularly, to a display device including a light control layer that controls a light extraction direction.

### DISCUSSION OF THE RELATED ART

Display devices are used in a variety of electronic devices such as television sets, mobile phones, tablet computers, and vehicle displays and development is underway to provide better and more dynamic display devices. For example, some display devices may provide capabilities for limiting the viewing angles that the display device can be viewed from so as to protect the security of data that is displayed thereon. Accordingly, research is being conducted on the stack structure of the display devices and optical elements included in the display devices to limit the viewing angle of the display devices.

### SUMMARY

A display device includes a display layer including a light emitting element, and a light control module disposed on the display layer. The light control module includes a pattern layer including a transmission portion and a light blocking portion, which cross one another in a first direction perpendicular to a thickness direction. A light control layer overlaps the pattern layer in the thickness direction, and the light control layer includes a lower light control layer disposed below the pattern layer and including a first portion overlapping the transmission portion and/or a second portion overlapping the light blocking portion and including a material that is different from that of the first portion or an upper light control layer disposed above the pattern layer and including a plurality of protrusions protruding in a direction away from the pattern layer.

The light control module may include the pattern layer and the lower light control layer, and the first portion of the lower light control layer may have a greater refractive index than each of the second portion and the transmission portion.

The first portion may have a refractive index of about 1.5 or more.

The light control module may include the pattern layer and the lower light control layer, and an upper surface of the first portion adjacent to the pattern layer may be a convex curved surface with respect to the transmission portion.

The first portion may have a greater level of liquid repellent properties as compared to the second portion.

The display device may further include an encapsulation layer including a lower inorganic film disposed directly on the display layer.

The encapsulation layer may further include an upper inorganic film disposed between the pattern layer and the lower light control layer.

The light control module may include the pattern layer and an upper light control layer disposed directly on an upper portion of the pattern layer.

Each of the protrusions of the upper light control layer may have a prism shape or a lens shape.

The light blocking portion may have an optical density of about 1.5 to about 2.0.

A first width of the transmission portion in the first direction may be greater than a second width of the light blocking portion in the first direction.

A display device includes a display panel including a plurality of light emitting regions and a peripheral region separating light emitting regions of the plurality of light emitting regions from one another. A light control module is disposed on the display panel and entirely overlaps the light emitting regions and the peripheral region. The light control module includes a pattern layer including a light blocking portion and a transmission portion, which cross one another in a first direction. A lower light control layer is disposed between the display panel and the pattern layer and includes a first portion overlapping the transmission portion and a second portion overlapping the light blocking portion. The first portion and the second portion include different materials from one another.

In the lower light control layer, the first portion may have a greater refractive index than each of the second portion and the transmission portion, and the first portion may have a refractive index of about 1.5 or more.

In the lower light control layer, an upper surface of the first portion may be a convex curved surface with respect to the transmission portion, and the first portion may have a greater level of liquid repellent properties as compared to the second portion.

The display device may further include a lower inorganic film disposed on the display panel. The second portion may include an organic film disposed on the lower inorganic film and an upper inorganic film disposed on the organic film.

The display device may further include an upper light control layer disposed on an upper portion of the pattern layer. An upper surface of the upper light control layer may include a plurality of protrusions protruding in a direction away from the pattern layer.

The plurality of transmission portions may overlap each of the light emitting regions.

The light blocking portion may include a light absorbing material or a light blocking material, and the light blocking portion may have an optical density of about 1.5 to about 2.0.

A display device includes a display layer including a light emitting element. An encapsulation layer is disposed on the display layer and includes a first encapsulation portion and a second encapsulation portion, which are alternately disposed in a first direction perpendicular to a thickness direction. A pattern layer is disposed on the encapsulation layer and includes a transmission portion overlapping the first encapsulation portion and a light blocking portion overlapping the second encapsulation portion. A light control layer is disposed below the pattern layer and includes a light control portion overlapping the transmission portion and disposed on the first encapsulation portion. The first encapsulation portion includes a lower inorganic film disposed directly on the display layer. The second encapsulation portion includes the lower inorganic film and an organic film stacked in a direction from the display layer to the pattern layer. A plurality of grooves are defined on an upper surface of the encapsulation layer by the first encapsulation portion and the second encapsulation portion. The light control portion is disposed in each of the grooves, and the light control portion and the organic film include different materials.

The light control portion may have a greater refractive index than each of the organic film and the transmission portion.

An upper surface of the light control portion adjacent to the pattern layer may be a convex curved surface with respect to the transmission portion.

The display device may further include an upper light control layer disposed on an upper portion of the pattern layer. An upper surface of the upper light control layer may include a plurality of protrusions protruding in a direction away from the pattern layer.

The encapsulation layer may further include an upper inorganic film. The upper inorganic film may be disposed exclusively on an upper portion of the organic film of the second encapsulation portion, or on an upper portion of the organic film of the second encapsulation portion and on an upper portion of the light control portion.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is an illustration showing the inside of a vehicle in which a display device of an embodiment is disposed;
FIG. 2 is a cross-sectional view of a display device of an embodiment;
FIG. 3 is a plan view of a display device of an embodiment;
FIG. 4 is a cross-sectional view of a display module according to an embodiment;
FIG. 5 is a cross-sectional view of a portion of a display module according to an embodiment;
FIG. 6A is a plan view showing the results of light extraction simulation in Comparative Example;
FIG. 6B is a plan view showing the results of light extraction simulation in Example;
FIG. 7A is a cross-sectional view showing light extraction characteristics in Comparative Example as an example;
FIG. 7B is a cross-sectional view showing light extraction characteristics in Example as an example;
FIG. 8 is a cross-sectional view of a display module according to an embodiment;
FIG. 9 is a cross-sectional view of a display module according to an embodiment;
FIG. 10A is a plan view showing the results of light extraction simulation in Comparative Example;
FIG. 10B is a plan view showing the results of light extraction simulation in Example;
FIG. 11 is a cross-sectional view showing light extraction characteristics in Example as an example;
FIG. 12 is a cross-sectional view of a display module according to an embodiment;
FIG. 13 is a cross-sectional view of a display module according to an embodiment;
FIG. 14A is a cross-sectional view of a light control module according to an embodiment;
FIG. 14B is a cross-sectional view of a light control module according to an embodiment;
FIG. 14C is a cross-sectional view of a light control module according to an embodiment;
FIG. 15 is a cross-sectional view showing light extraction characteristics in Example as an example;
FIG. 16A is a plan view showing the results of light extraction simulation in Comparative Example;
FIG. 16B is a plan view showing the results of light extraction simulation in Example;
FIG. 16C is a plan view showing the results of light extraction simulation in Example;
FIG. 17 is a cross-sectional view of a display module according to an embodiment;
FIGS. 18A to 18E are each cross-sectional views schematically showing a step in a method for manufacturing a display device according to an embodiment; and
FIGS. 19A and 19B are each cross-sectional views schematically showing a step in a method for manufacturing a display device according to an embodiment.

### DETAILED DESCRIPTION

The present disclosure may be modified in many alternate forms, and thus specific embodiments will be exemplified in the drawings and described in detail.

It will be understood that when an element (or a region, a layer, a portion, or the like) is referred to as "being on", "connected to" or "coupled to" another element, it may be disposed directly on, connected or coupled to the other element, or intervening elements may be disposed therebetween.

Like reference numerals may refer to like elements throughout the specification and the drawings. While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like. The term "and/or," includes all combinations of one or more of which associated configurations may define.

It will be understood that, although the terms first, second, etc. may be used herein to describe various elements, these elements should not necessarily be limited by these terms. These terms may be used to distinguish one element from another element. For example, a first element may be referred to as a second element, and similarly, a second element may be referred to as a first element without departing from the teachings of the present disclosure. The singular forms are intended to include the plural forms as well, unless the context clearly indicates otherwise.

Also, terms of "below", "on lower side", "above", "on upper side", or the like may be used to describe the relationships of the components shown in the drawings. The terms are used as a relative concept and are described with reference to the direction indicated in the drawings.

It should be understood that the terms "comprise", or "have" are intended to specify the presence of stated features, integers, steps, operations, elements, components, or combinations thereof in the disclosure, but do not preclude the presence or addition of one or more other features, integers, steps, operations, elements, components, or combinations thereof.

As used herein, being "disposed directly on" may mean that there is no additional layer, film, region, plate, or the like between a part and another part such as a layer, a film, a region, a plate, or the like. For example, being "disposed directly on" may mean that two layers or two elements are disposed without using an additional element such as an adhesive, disposed therebetween.

Hereinafter, a display device according to an embodiment will be described with reference to the accompanying drawings.

The display device according to an embodiment may be a device activated in response to electrical signals. The display device may be applied to electronic devices such as mobile phones, smart watches, tablet computers, laptop computers, computer monitors, and smart televisions. In addition, the display device of an embodiment may be applied to transportation devices such as vehicles. The display device applied to transportation devices may be applied inside the transportation devices to provide users with a variety of information through images.

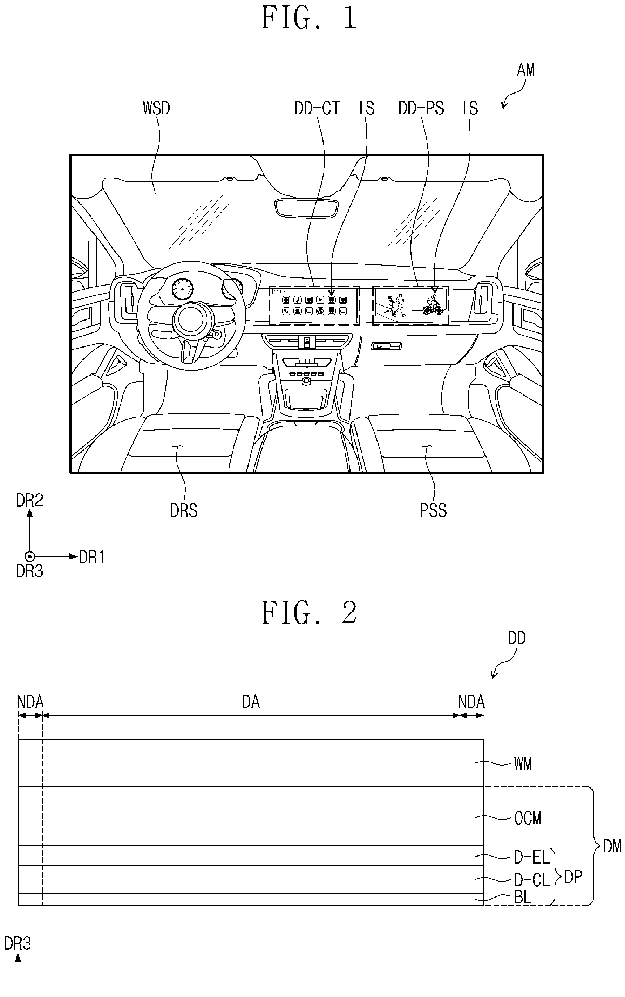

FIG. 1 is an illustration showing the inside of a vehicle AM in which a plurality of display devices DD-CT and DD-PS are disposed. The display devices DD-CT and DD-PS disposed inside the vehicle AM may correspond to the display device of an embodiment, which will be described later.

The display devices DD-CT and DD-PS in an embodiment are disposed inside the vehicle AM and may thus provide users in a driver seat DRS or a passenger seat PSS with a varied selection of information. The display devices DD-CT and DD-PS may display images on a display surface IS. The display surface IS on which the image is displayed may correspond to a front surface of the display devices DD-CT and DD-PS. Images may include still images as well as dynamic (video) images.

The display surface IS may be parallel to each of a first direction DR1 and a second direction DR2. However, the embodiment of the inventive concept is not necessarily limited thereto, and the display surface IS of the display device may include a curved surface to embrace the interior design of vehicles, or may include a plane defined by the first direction DR1 and the second direction DR2 and an inclined plane. A normal direction of the display surface IS, for example, a thickness direction of the display devices DD-CT and DD-PS, is indicated by a third direction DR3.

FIG. 1 and the following drawings show first to third directional axes DR1 to DR3, and directions indicated by the first to third directional axes DR1, DR2, and DR3 described herein are relative concepts, and may thus be changed to other directions. In addition, the directions indicated by the first to third directional axes DR1, DR2, and DR3 may be described as first to third directions DR1, DR2, and DR3, and the same reference numerals may be used. The first directional axis DR1 and the second directional axis DR2 herein may be perpendicular to each other, and the third directional axis DR3 may be a normal direction with respect to a plane defined by the first directional axis DR1 and the second directional axis DR2.

Herein, the first direction DR1 may be referred to as a left-right direction, the second direction DR2 may be referred to as an up-down direction, and the third direction DR3 may be referred to as a thickness direction.

A thickness direction of the display device DD may be parallel to the third directional axis DR3 which is a normal direction with respect to the plane defined by the first directional axis DR1 and the second directional axis DR2. Herein, a front surface (or an upper surface) and a rear surface (or a lower surface) of elements constituting the display device DD may be defined with respect to the third directional axis DR3. The front surface (or upper surface) and the rear surface (or lower surface) of each element constituting the electronic device DD may oppose each other in the third direction DR3 and a normal direction of each of the front and rear surfaces may substantially be parallel to the third direction DR3. A distance between the front surface and the rear surface defined along the third direction DR3 may correspond to a thickness of an element.

In addition, herein, "when viewed on a plane" or "in a plan view" may be defined as a state viewed in the third direction DR3. Herein, "when viewed on a cross-section" or "in a cross-sectional view" may be defined as a state viewed in the first direction DR1 or the second direction DR2.

In FIG. 1, the display surface IS is shown to have a rectangular shape on a plane, but this is presented as an example, and the display surface IS may have various shapes and is not necessarily limited to any one shape embodiment.

Referring to FIG. 1, a first display device DD-PS may be disposed in a position facing the passenger seat PSS. The first display device DD-PS may display information needed during driving, such as vehicle status information, vehicle internal operation information, and navigation information, and may also display various information unrelated to driving. For safety reasons, while driving, a user in the driver seat DRS may be prevented from being provided with images displayed on the first display device DD-PS. For example, it is desirable that considering the view range of the user in the driver seat DRS, ranges of a side viewing angle where the images displayed on the first display device DD-PS are viewed are controlled so as not to affect the driver, for example, so as not to distract the driver while driving. Accordingly, the first display device DD-PS includes the display device of an embodiment which will be described later to make an optical path in the left and right directions (e.g., the first direction DR1) limited by a light control module, and may thus provide images highly visible to users without disturbing the driver.

A second display device DD-CT disposed inside the vehicle AM may be a center information display (CID). The second display device DD-CT may be mounted on a dashboard between the driver seat DRS and the passenger seat PSS. The second display device DD-CT may collectively display various information to the user in the driver seat DRS or in the passenger seat PSS. In the second display device DD-CT, the viewing angle may be limited in the up-down direction (e.g., the second direction DR2). When the images displayed on the second display device DD-CT are displayed in a wide angle range in the up-down direction, light emitted from the second display device DD-CT may reach vehicle windshield WSD and generate reflected light. In this case, the driver may be distracted by the reflected light. Accordingly, in an embodiment, the second display device DD-CT of the vehicle AM includes the display device of an embodiment which will be described later to make the optical path in the up-down direction limited by a light control module so as to reduce the light transmitted to the windshield WSD, and may thus provide images highly visible to users but are also not distracting to the driver.

FIG. 2 is a cross-sectional view of a display device according to an embodiment. The display device DD may include a display module DM and a window module WM disposed on the display module DM. The display module DM may include a display panel DP and a light control module OCM.

The window module WM may be disposed above the display module DM and may cover an entire upper surface of the display module DM. A front surface of the window module WM may define the display surface IS of the display device DD. The window module WM may have a shape corresponding to the shape of the display module DM.

The window module WM may include a substrate or a film containing glass or a polymer material. In addition, the window module WM may further include a functional layer such as a protection film disposed on an upper surface of the substrate or the film, which serves as a base. The window module WM may further include an adhesive layer for bonding to the display module DM. The adhesive layer may be an optically clear adhesive (OCA) layer. In an embodiment, the window module WM might not be provided.

The display panel DP may include a base layer BL, a circuit element layer D-CL, and a display layer D-EL. The display panel DP may be configured to substantially generate images.

The display panel DP included in the display device DD according to an embodiment may be an organic light emitting display panel, an inorganic light emitting display panel, an organic-inorganic light emitting display panel, a quantum dot display panel, a micro LED display panel, or a nano LED display panel. In the present embodiment, a case in which the display panel DP is an organic light emitting display panel is taken as an example, but the embodiment of the inventive concept is not necessarily limited thereto.

In the display panel DP, the base layer BL may be an element providing a base surface in which the display layer D-EL is disposed. The base layer BL may be rigid or flexible. The base layer BL may be a glass substrate, a metal substrate, a polymer substrate, or the like. However, the embodiment of the inventive concept is not necessarily limited thereto, and the base layer BL may be an inorganic layer, an organic layer, or a complex material layer.

The base layer BL may have a single-layer structure as well as a multi-layer structure. For example, the base layer BL may have a three-layer structure of a polymer resin layer, an adhesive layer, and a polymer resin layer. In particular, the polymer resin layer may include a polyimide-based resin. In addition, the polymer resin layer may include an acrylate-based resin, a vinyl-based resin, an epoxy-based resin, a urethane-based resin, a cellulose-based resin, a siloxane-based resin, and/or a perylene-based resin. As described herein, a resin that is based on a material may be considered as including a functional group of that material.

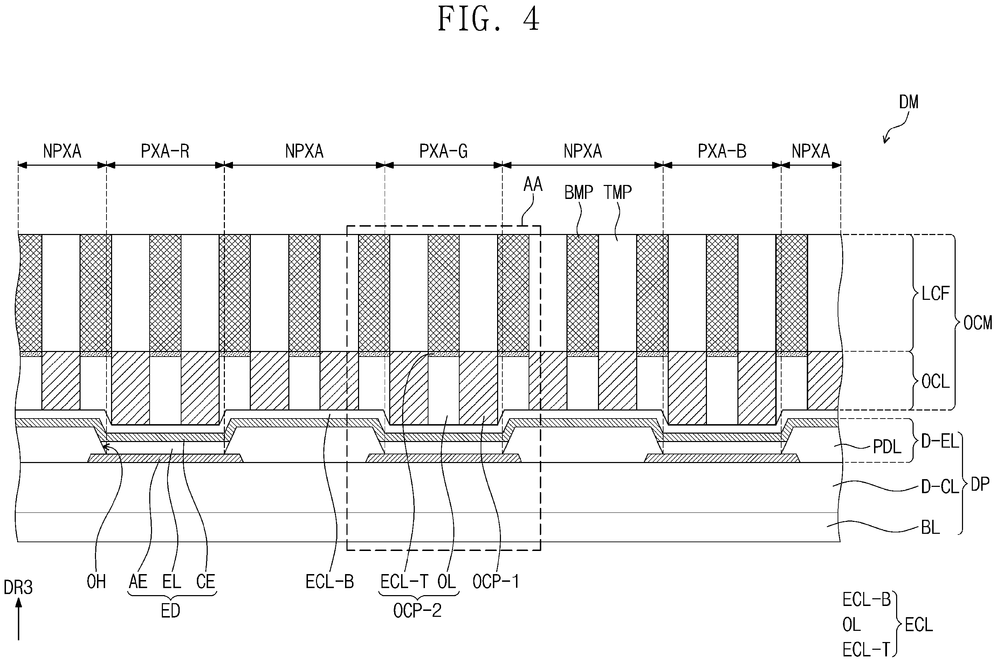

The circuit element layer D-CL may be disposed on the base layer BL. The circuit element layer D-CL may include an insulating layer, a semiconductor pattern, a conductive pattern, and a signal line. The circuit element layer D-CL may include a plurality of transistors formed of the semiconductor pattern, the conductive pattern, and the signal line. The transistors may each include a control electrode, an input electrode, and an output electrode. For example, the circuit element layer D-CL may include a switching transistor and a driving transistor for driving a light emitting element ED (FIG. 4).

The display layer D-EL may be disposed on the circuit element layer D-CL. The display layer D-EL may be a layer including a display element. The display element may include the light emitting element ED (FIG. 4) that generates and emits light. Light generated in the display layer D-EL may pass through the light control module OCM on an upper portion of the display layer D-EL and be emitted to an upper surface of the display device DD.

The light control module OCM may be disposed on the upper portion of the display layer D-EL. The light control module OCM may control the light extraction direction of light emitted from the display layer D-EL. The display device DD, according to an embodiment, includes the light control module OCM to limit light emitted broadly in the left-right direction or to limit light emitted widely in the up-down direction, and may thus provide high luminance in the limited viewing angle ranges and exhibit excellent display quality.

The display device DD may include a display region DA and a non-display region NDA. The non-display region NDA may be disposed outside at least one side of the display region DA. In an embodiment, the non-display region NDA may be a region surrounding the display region DA. However, the non-display region NDA is not necessarily limited thereto, and the non-display region NDA might not be provided in an embodiment of the inventive concept.

The display module DM may further include an input sensor. The input sensor may acquire coordinate information of external inputs. The input sensor may detect external inputs using a capacitance method, an electromagnetic induction method, or a pressure detection method. The input sensor may be disposed below a light control layer OCL, which will be described later.

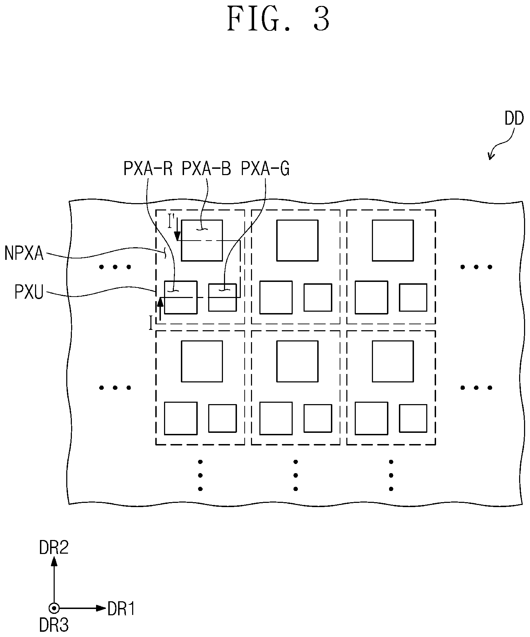

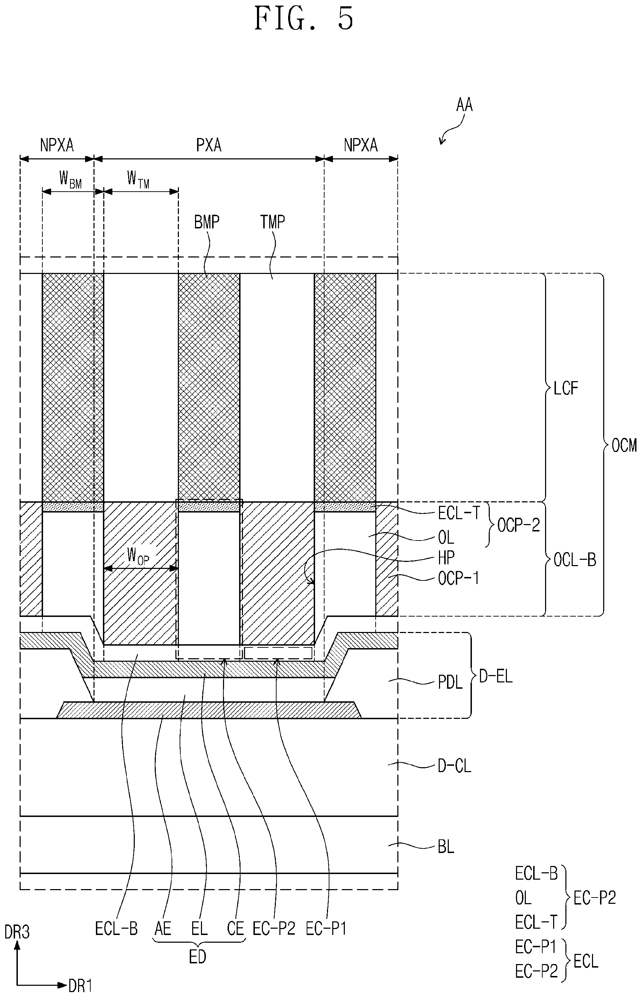

FIG. 3 is a plan view showing a partial region of the display device according to an embodiment. FIG. 3 is a plan view showing a partial region of the display region DA (FIG. 2). FIG. 4 is a cross-sectional view showing a portion of a display module according to an embodiment. FIG. 4 is a cross-sectional view corresponding to line I-I' of FIG. 3. FIG. 5 is a cross-sectional view enlarging a portion corresponding to region AA of FIG. 4.

Referring to FIGS. 3 and 4, the display device DD of an embodiment may include a plurality of light emitting regions PXA-R, PXA-G, and PXA-B and a peripheral region NPXA disposed among the light emitting regions PXA-R, PXA-G, and PXA-B.

The display device DD of an embodiment may include three types of light emitting regions PXA-R, PXA-G, and PXA-B, which are distinct from one another. In an embodiment, the three types of light emitting regions PXA-R, PXA-G, and PXA-B shown in FIG. 3 may be repeatedly disposed throughout the display region DA (FIG. 2). The light emitting regions PXA-R, PXA-G, and PXA-B may also be referred to as pixel regions. In the display region DA (FIG. 2), a first light emitting region PXA-R, a second light emitting region PXA-G, and a third light emitting region PXA-B, which emit light in different wavelength ranges and are spaced apart when viewed on a plane.

The first to third light emitting regions PXA-R, PXA-G, and PXA-B might not overlap and may be separated from one another when viewed on a plane. The first to third light emitting regions PXA-R, PXA-G, and PXA-B may each be defined as a region in which an upper surface of a first electrode AE is exposed by a light emitting opening OH.

In an embodiment, the first light emitting region PXA-R may be a red light emitting region emitting red light, the second light emitting region PXA-G may be a green light emitting region emitting green light, and the third light emitting region PXA-B may be a blue light emitting region emitting blue light. However, the embodiment of the inventive concept is not necessarily limited thereto, and in an embodiment, the display region DA may further include a white light emitting region that emits white light, in addition to the first to third light emitting regions PXA-R, PXA-G, and PXA-B.

In addition, the display region DA (FIG. 2) includes the peripheral region NPXA. The peripheral region NPXA may be referred to as a non-light emitting region.

The peripheral region NPXA is disposed around the first to third light emitting regions PXA-R, PXA-G, and PXA-B. The peripheral region NPXA sets boundaries between the first to third light emitting regions PXA-R, PXA-G, and PXA-B. The peripheral region NPXA may surround the first to third light emitting region PXA-R, PXA-G, and PXA-B. A structure that prevents color mixing between the first to third light emitting regions PXA-R, PXA-G, and PXA-B, for example, a pixel defining layer PDL (FIG. 4) may be disposed correspondingly in the peripheral region NPXA.

In an embodiment, in the display region DA (FIG. 2), a plurality of pixel units PXU may be disposed. In an embodiment, the pixel units PXU may each be arranged in the first direction DR1 and the second direction DR2. The pixel units PXU may define pixel rows and pixel columns. The pixel units PXU may include at least one pixel. The pixel units PXU may include a first pixel, a second pixel, and a third pixel, which emit light in different wavelength ranges. Red light, green light, and blue light may be emitted from the first pixel, the second pixel, and the third pixel, respectively. The first light emitting region PXA-R may be a region in which light generated from the first pixel is provided to the outside, the second light emitting region PXA-G may be a region in which light generated from the second pixel is provided to the outside, and the third light emitting region PXA-B may be a region in which light generated from the third pixel is provided to the outside. For example, one pixel unit PXU may be composed of the first light emitting region PXA-R, the second light emitting region PXA-G, and the third light emitting region PXA-B. However, the embodiment of the inventive concept is not necessarily limited thereto, and the type and number of light emitting regions constituting one pixel unit PXU may vary depending on the display quality required for the display device.

FIG. 3 shows, as an example, a display device DD that includes the first to third light emitting regions PXA-R, PXA-G, and PXA-B having the same planar shape and having different planar areas, but the embodiment of the inventive concept is not necessarily limited thereto. The first to third light emitting regions PXA-R, PXA-G, and PXA-B may all have an area of the same size, or at least one type of light emitting region may have an area of a different size from the other types of light emitting regions. The areas of the first to third light emitting regions PXA-R, PXA-G, and PXA-B may be set according to the color of emitted light. The area of the light emitting regions may be an area, when viewed on a plane, defined by the first direction DR1 and the second direction DR2.

Referring to FIG. 3, the first to third light emitting regions PXA-R, PXA-G, and PXA-B may have a rectangular shape when viewed on a plane. However, the embodiment of the inventive concept is not necessarily limited thereto, and when view on a plane, the first to third light emitting regions PXA-R, PXA-G, and PXA-B may have any other polygonal shapes such as a rhombus or a pentagon (including substantially polygonal shapes). The first to third light emitting regions PXA-R, PXA-G, and PXA-B may have a rectangular shape having rounded corners (a substantially rectangular shape) when viewed on a plane.

FIG. 3 shows, as an example, that the third light emitting region PXA-B is disposed in a first row, and the first light emitting region PXA-R and the second light emitting region PXA-G are disposed in a second row, but the embodiment of the inventive concept is not necessarily limited thereto, and the arrangement of the first to third light emitting regions PXA-R, PXA-G, and PXA-B may be variously modified. For example, the first to third light emitting regions PXA-R, PXA-G, and PXA-B constituting one pixel unit PXU may be disposed in the same row.

For example, the plurality of light emitting regions PXA-R, PXA-G, and PXA-B may be arranged in the form of a stripe or may be arranged in the form of a pentile (PENTILE^{™}) or a diamond (DIAMOND PIXEL^{™}) wherein PENTILE and DIAMOND PIXEL are arrangements of luminous areas manufactured by SAMSUNG. However, the embodiment of the inventive concept is not necessarily limited thereto, and the order and arrangement that the plurality of light emitting regions PXA-R, PXA-G, and PXA-B are arranged come with varied combination according to display quality characteristics required for the display device DD.

Referring to FIGS. 4 and 5, the display module DM, according to an embodiment, may include a display panel DP and a light control module OCM disposed on the display panel DP. The light control module OCM may include a pattern layer LCF and a light control layer OCL. In an embodiment, the light control layer OCL may be disposed on an upper portion and/or a lower portion of the pattern layer LCF.

The light control module OCM is disposed on an upper portion of the display panel DP and may thus control emission characteristics of light generated from the display panel DP and extracted to the outside. In an embodiment, the light control module OCM may increase light extraction efficiency in a front direction and block light directed in a side direction at a certain angle or greater. The light control module OCM, according to an embodiment, will be described in more detail later.

In an embodiment, the display panel DP may include a base layer BL, a circuit element layer D-CL disposed on the base layer BL, and a display layer D-EL disposed on the circuit element layer D-CL. In addition, the display layer D-EL may include a pixel defining layer PDL and a light emitting element ED. An encapsulation layer ECL may be disposed on the display panel DP. The encapsulation layer ECL may cover an upper portion of the light emitting element ED.

The light emitting element ED may include a first electrode AE, a second electrode CE, and a functional layer EL disposed between the first electrode AE and the second electrode CE.

The first electrode AE may be disposed on the circuit element layer D-CL. The first electrode AE may be an anode or a cathode. In addition, the first electrode AE may be a pixel electrode. The second electrode CE may face the first electrode AE. The second electrode CE may be a cathode or an anode. The second electrode CE may be a common electrode. For example, when the first electrode AE is an anode, the second electrode CE may be a cathode, and when the first electrode AE is a cathode, the second electrode CE may be an anode.

The functional layer EL may include at least one light emitting structure. The functional layer EL may include an emission layer patterned to correspond to each of the plurality of light emitting regions PXA-R, PXA-G, and PXA-B. Although not separately shown in FIG. 4, the emission layer patterned and provided to correspond to each of the light emitting regions PXA-R, PXA-G, and PXA-B may emit light in different wavelength ranges. In addition, the functional layer EL may include at least one organic layer commonly provided in the light emitting regions PXA-R, PXA-G, and PXA-B. For example, the functional layer EL may include a common layer commonly provided to the plurality of light emitting regions PXA-R, PXA-G, and PXA-B, and the emission layer patterned corresponding to each of the light emitting regions PXA-R, PXA-G, and PXA-B (FIG. 5). The common layer may serve for hole transport or electron transport.

The display layer D-EL includes the pixel defining layer PDL disposed on the circuit element layer D-CL. A light emitting opening OH is defined in the pixel defining layer PDL. The light emitting opening OH of the pixel defining layer PDL allows at least a portion of the first electrode AE to be exposed. In an embodiment, the pixel defining layer PDL may cover an edge of the first electrode AE.

The pixel defining layer PDL may have a single-layer structure or a multi-layer structure. The pixel defining layer PDL may include a polymer resin. For example, the pixel defining layer PDL may include a polyacrylate-based resin or a polyimide-based resin. In addition, the pixel defining layer PDL may be formed by further including an inorganic material in addition to the polymer resin. The pixel defining layer PDL may include a light absorbing material, or may include a black pigment or a black dye. The pixel defining layer PDL including a black pigment or a black dye may implement a black pixel defining layer. When forming the pixel defining layer PDL, carbon black may be used as a black pigment or a black dye, but the embodiment of the inventive concept is not necessarily limited thereto.

In addition, the pixel defining layer PDL may include an inorganic material. For example, the pixel defining layer PDL may include silicon nitride (SiNx), silicon oxide (SiOx), silicon oxynitride (SiOxNy), or the like.

The encapsulation layer ECL may be disposed on the second electrode CE of the light emitting element ED. The encapsulation layer ECL may be a single layer or a stack of a plurality of layers. The encapsulation layer ECL includes at least one insulating layer. The encapsulation layer ECL, according to an embodiment, may include at least one inorganic film (hereinafter, a lower inorganic film or an upper inorganic film). In addition, the encapsulation layer ECL, according to an embodiment, may include at least one organic film and at least one inorganic film. Some of the plurality of layers constituting the encapsulation layer ECL may increase the optical efficiency of the light emitting element, and some may protect the light emitting element.

The inorganic film of the encapsulation layer ECL protects the light emitting element ED from moisture/oxygen, and the organic film of the encapsulation layer ECL protects the light emitting element ED from foreign substances such as dust particles. The inorganic film may include silicon nitride, silicon oxy nitride, silicon oxide, titanium oxide, aluminum oxide, and the like, but is not necessarily particularly limited thereto. The organic film may include an acryl-based compound, an epoxy-based compound, and the like. The organic film may include a photopolymerizable organic material, and is not necessarily particularly limited thereto.

Referring to FIGS. 4 and 5, in the display module DM, according to an embodiment, the encapsulation layer ECL may include a lower inorganic film ECL-B. The lower inorganic film ECL-B may be disposed directly on the display panel DP. The encapsulation layer ECL may include an organic film OL disposed on the lower inorganic film ECL-B, and an upper inorganic film ECL-T disposed on the organic film OL.

In an embodiment, the encapsulation layer ECL may include a first encapsulation portion EC-P1 and a second encapsulation portion EC-P2. The first encapsulation portion EC-P1 may be a portion including the lower inorganic film ECL-B, and the second encapsulation portion EC-P2 may be a portion including the lower inorganic film ECL-B stacked in the third direction DR3. Unlike what is shown, in an embodiment, the upper inorganic film ECL-T of the second encapsulation portion EC-P2 might not be provided. For example, the second encapsulation portion EC-P2 may include the lower inorganic film ECL-B and the organic film OL.

In the encapsulation layer ECL, the lower inorganic film ECL-B and the upper inorganic film ECL-T may each independently be formed from the inorganic film materials of the encapsulation layer ECL described above. In addition, the organic film OL may include the organic film materials described above.

In an embodiment, the first encapsulation portion EC-P1 and the second encapsulation portion EC-P2 may be alternately and repeatedly disposed in one direction. In FIG. 4 and the drawings herein below, the first encapsulation portion EC-P1 and the second encapsulation portion EC-P2 are shown to be repeatedly disposed to alternate in the first direction DR1. However, the embodiment of the inventive concept is not necessarily limited thereto, and the first encapsulation portion EC-P1 and the second encapsulation portion EC-P2 may be alternately and repeatedly disposed in any one direction crossing the third direction DR3, which is the thickness direction. In an embodiment, the direction in which the first encapsulation portion EC-P1 and the second encapsulation portion EC-P2 are alternately disposed may be the same as a direction in which a transmission portion TMP and a light blocking portion BMP are alternately disposed, which will be described later.

A plurality of grooves HP may be defined on an upper surface of the encapsulation layer ECL according to an embodiment. The grooves HP may be defined by the first encapsulation portion EC-P1 and the second encapsulation portion EC-P2, which are alternately disposed in one direction. For example, in an embodiment, the encapsulation layer ECL may have a trench structure.

In the display device DD of an embodiment shown in FIGS. 4 and 5, the light control module OCM may include a pattern layer LCF and a light control layer OCL disposed below the pattern layer LCF. The light control layer OCL may be a lower light control layer OCL-B.

The pattern layer LCF may include the transmission portion TMP and the light blocking portion BMP alternately disposed in one direction. The transmission portion TMP and the light blocking portion BMP may be portions having differences in light transmittance. Light transmitted from the display panel DP to the light blocking portion BMP may be absorbed in the light blocking portion BMP. In addition, some of the light transmitted to the light blocking portion BMP may be reflected from the light blocking portion BMP.

The light blocking portion BMP may include a light absorbing material or a light blocking material. The light blocking portion BMP may have an optical density OD of about 1.5 to about 2.0. The light blocking portion BMP includes a material having an optical density OD of about 1.5 to about 2.0, and accordingly, the reflectance of light reflected without being absorbed in the light blocking portion BMP is reduced and excellent absorbance may be exhibited.

The transmission portion TMP may be a portion having higher light transmittance than the light blocking portion BMP. The transmission portion TMP may be a portion formed of a transparent resin.

Light emitted from the display panel DP and provided to the pattern layer LCF may be transmitted through the transmission portion TMP, extracted to the outside, and absorbed in the light blocking portion BMP. The pattern layer LCF includes the transmission portion TMP and the light blocking portion BMP, which are alternately arranged in one direction, and may thus limit an exit angle of light diffused and emitted in one direction.

In FIG. 4 and the like, the transmission portion TMP and the light blocking portion BMP are shown to be alternately arranged in the first direction DR1 in the pattern layer LCF according to an embodiment. However, the embodiment of the inventive concept is not necessarily limited thereto, and the transmission portion TMP and the light blocking portion BMP may be alternately and repeatedly disposed in any direction crossing the third direction DR3, which is the thickness direction. The transmission portion TMP and the light blocking portion BMP may be arranged in consideration of a direction in which a viewing angle needs to be limited in the display device. For example, the pattern layer LCF including the transmission portion TMP and the light blocking portion BMP alternately and repeatedly arranged in the first direction DR1 is included in the display device DD-PS and DD-CT shown in FIG. 1, and accordingly, the exit angle of light in the left-right direction may be limited. When the display devices DD-PS and DD-CT include the pattern layer LCF in which the transmission portion TMP and the light blocking portion BMP are alternately and repeatedly arranged in the second direction DR2, the display devices DD-PS and DD-CT may exhibit characteristics in which the exit angle of light in the up-down direction is limited.

In an embodiment, the transmission portion TMP may overlap the first encapsulation portion EC-P1, and the light blocking portion BMP may overlap the second encapsulation portion EC-P2. In an embodiment, the first encapsulation portion EC-P1 may entirely overlap the transmission portion TMP. In an embodiment, a border between the transmission portion TMP and the light blocking portion BMP may overlap a border between the first encapsulation portion EC-P1 and the second encapsulation portion EC-P2. However, the embodiment of the inventive concept is not necessarily limited thereto.

The pattern layer LCF may overlap the entire display region DA (FIG. 2). The pattern layer LCF may overlap both the light emitting region PXA-R, PXA-G, and PXA-B and the peripheral region NPXA. Each of the light emitting regions PXA-R, PXA-G, and PXA-B may overlap a plurality of transmission portions TMP. In FIG. 4 and the like, two transmission portions TMP are shown to overlap one light emitting region PXA, but the embodiment of the inventive concept is not necessarily limited thereto, and considering luminance characteristics and viewing angle control characteristics required for the display device, the number of transmission portions TMP and light blocking portions BMP overlapping one light emitting region PXA may be set.

In the pattern layer LCF of an embodiment, a first width W_{TM} of the transmission portion TMP in one direction may be greater than a second width W_{BM} of the light blocking portion BMP in one direction. For example, the first width W_{TM} of the transmission portion TMP may be about 4 µm to about 5 µm, and the second width W_{BM} of the light blocking portion BMP may be about 3 µm to about 4 µm. However, the embodiment of the inventive concept is not necessarily limited thereto, and the ratio of the widths of the transmission portion TMP and the light blocking portion BMP may be regulated in consideration of the luminance characteristics and viewing angle control characteristics required for the display device.

Referring to FIGS. 4 and 5, the light control module OCM, according to an embodiment, may include a lower light control layer OCL-B disposed below the pattern layer LCF.

The lower light control layer OCL-B may include a first portion OCP-1 and a second portion OCP-2, which are alternately arranged in one direction. The first portion OCP-1 may overlap the transmission portion TMP, and the second portion OCP-2 may overlap the light blocking portion BMP. The second portion OCP-2 of the lower light control layer OCL-B may correspond to a portion including the organic film OL, of the second encapsulation portion EC-P2. In an embodiment, the second portion OCP-2 may correspond to the organic film OL portion of the second encapsulation portion EC-P2 or correspond to a portion including the organic film OL and the upper inorganic film ECL-T of the second encapsulation portion EC-P2.

The first portion OCP-1 may also be referred to as a light control portion. The first portion OCP-1, which is a light control portion, may be disposed on the first encapsulation portion EC-P1. For example, in an embodiment, the first portion OCP-1 of the lower light control layer OCL-B may be disposed in the groove HP of the encapsulation layer ECL. The first portion OCP-1 of the lower light control layer OCL-B may fill the groove HP. The width Wor of the first potion OCP-1 may correspond to the first width W_{TM} of the transmission portion TMP.

The first portion OCP-1 and the second portion OCP-2 may include different materials from one another. The first portion OCP-1 and the second portion OCP-2 may include different materials, and the first portion OCP-1 and the second portion OCP-2 may be different in optical properties or different in physical and chemical properties.

The first portion OCP-1 may have a greater refractive index than the transmission portion TMP. In addition, in an embodiment, the refractive index of the first portion OCP-1 may be greater than each of the refractive index of the second portion OCP-2 and the refractive index of the transmission portion TMP. For example, the refractive index of the first portion OCP-1 may be greater than the refractive index of the organic film OL constituting the second portion OCP-2.

The first portion OCP-1 may include a polymer material, and may be formed through polymerization from organic monomers having high refractive properties. The material of the first portion OCP-1 is not necessarily particularly limited thereto, and any organic material having a refractive index greater than that of the transmission portion TMP may be used without limitation. The first portion OCP-1 may be formed through polymerization from organic monomers having a functional group with high refractive properties. The first portion OCP-1 may further include scatterers in addition to the high refractive polymer material.

The refractive index of the first portion OCP-1 may be greater than about 1.5. There may be a difference of 0.1 or greater in the refractive index between the first portion OCP-1 and the transmission portion TMP. For example, the refractive index of the transmission portion TMP may be about 1.4. In addition, there may be a difference of 0.1 or greater in the refractive index between the first portion OCP-1 and the second portion OCP-2. For example, the refractive index of the organic film OL of the second portion OCP-2 may be about 1.4. However, the embodiment of the inventive concept is not necessarily limited thereto.

The light control module OCM, according to an embodiment, includes a lower light control layer OCL-B including a first portion OCP-1 that overlaps the transmission portion TMP of the pattern layer LCF and has a greater refractive index than the transmission portion TMP, and may thus exhibit limited light extraction in one direction. The first portion OCP-1 overlapping the transmission portion TMP and having relatively high refractive characteristics is disposed below the transmission portion TMP, and accordingly, an incidence angle of light incident from the first portion OCP-1 to the transmission portion TMP may be regulated. For example, when light is incident from the first portion OCP-1 to the transmission portion TMP by the first portion OCP-1 having a higher refractive index than the transmission portion TMP, the light refracted and directed to the light blocking portion BMP may be minimized. Accordingly, a phenomenon of light diffusing when reflected and emitted from the side of the light blocking portion BMP may be minimized.

In an embodiment shown in FIG. 5, and the like, the lower light control layer OCL-B including the first portion OCP-1 having high refractive characteristics is included, and thus light generated in the display layer D-EL and extracted toward the outside may be prevented from spreading widely. Accordingly, the display device of an embodiment may exhibit required limited viewing angle characteristics by limiting and controlling light emitted widely to the sides and also exhibit excellent front luminance characteristics.

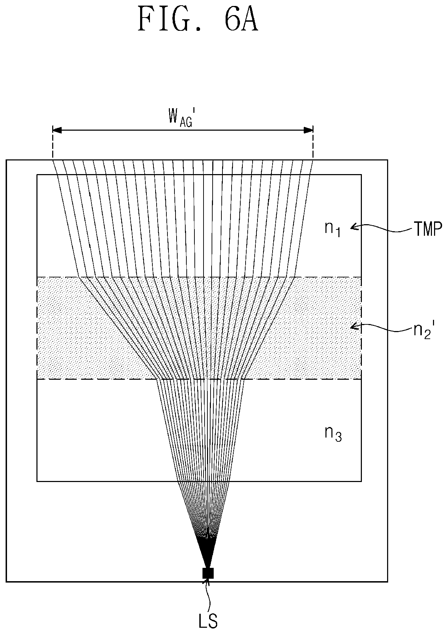

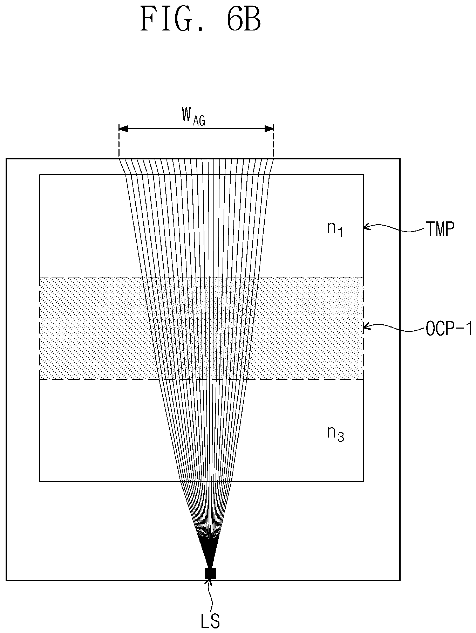

FIGS. 6A and 6B each show the results of light extraction simulation. FIG. 6A shows the results of light extraction simulation for Comparative Example, and FIG. 6B shows the results of light extraction simulation that illustratively reflects the optical characteristics of a light control module in the display device of an embodiment. The light extraction simulation results described in FIGS. 6A and 6B and described hereinafter were evaluated using ray optics simulation.

FIGS. 6A and 6B show the results of simulating light output patterns by altering only the refractive index conditions of n2' and n2 while keeping other conditions the same. FIGS. 6A and 6B show the results of simulating exit angles of light emitted from a light source LS in the conditions that n1 and n3 each have a refractive index of 1.5, n2' has a refractive index of 0.5, and n2 has a refractive index of 2.0.

In FIG. 6B, a portion having a refractive index of n2 may correspond to the first portion OCP-1 (FIG. 5) of the lower light control layer according to an embodiment of the inventive concept, and a portion having a refractive index of n1 may correspond to the transmission portion TMP (FIG. 5) of the pattern layer according to an embodiment of the inventive concept.

Referring to FIGS. 6A and 6B, FIG. 6B having a structure in which a first portion OCP-1 having a relatively large refractive index and a transmission portion TMP having a smaller refractive index than the first portion OCP-1 are stacked shows the reduced light output range compared to FIG. 6A in which a layer having a relatively low refractive index is disposed below the transmission portion TMP.

A light output range W_{AG} in FIG. 6B may be reduced compared to a light output range W_{AG}' in FIG. 6A. Herein, the light output range may indicate the extent to which the emitted light is spread laterally. For example, when referring to the simulation results shown in FIGS. 6A and 6B, it is seen that the case of an embodiment in which the first portion OCP-1 having a large refractive index is disposed below the transmission portion TMP allow a better collimation of the emitted light.

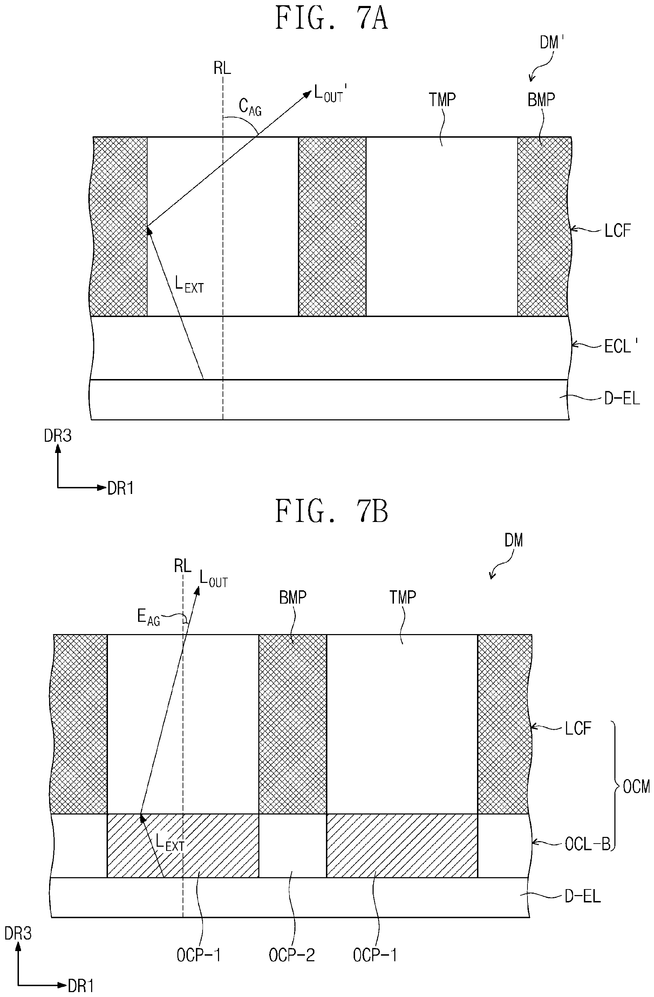

FIGS. 7A and 7B are each views showing light extraction characteristics in a display module. FIG. 7A corresponds to a case where, unlike the configuration of the encapsulation layer ECL according to an embodiment shown in FIG. 7B, an encapsulation layer ECL' is not divided into two portions having different characteristics, but formed as a single body. In a display module DM' according to a Comparative Example shown in FIG. 7A, a refractive index of the encapsulation layer ECL' may be equal to or smaller than a refractive index of the transmission portion TMP.

In the structure of the display module DM' shown in FIG. 7A, light L_{EXT} emitted from the display layer D-EL and incident on the encapsulation layer ECL' may be incident on the transmission portion TMP at an inclination angle, and reflected from the side of the light blocking portion BMP. Light L_{OUT}' reflected from the light blocking portion BMP and finally emitted to the outside may be emitted to be deviated in the side direction from a front direction parallel to the third direction DR3.

FIG. 7B shows a display module DM, according to an embodiment, as an example, and a portion of the light emitted from the display layer D-EL and incident on the first portion OCP-1 of the lower light control layer OCL-B may be redirected at a border between the first portion OCP-1 and the transmission portion TMP, and accordingly, the phenomenon of light being reflected from the light blocking portion BMP may be reduced. For example, in the light emitted from the display layer D-EL, the light L_{EXT} incident on the lower light control layer OCL-B in the side direction instead of the front direction may be redirected in a stack structure of a first portion OCP-1 having a high refractive index and a transmission portion TMP having a lower refractive index than the first portion OCP-1. Accordingly, the light incident on the transmission portion TMP and directed to the light blocking portion BMP may be minimized, and an exit angle E_{AG} of the emitted light L_{OUT} may be smaller than an exit angle C_{AG} of the emitted light L_{OUT}' illustratively shown and described in FIG. 7A. For example, in an embodiment, the exit angle E_{AG} of the emitted light L_{OUT} may be about 3° or less to one side in the front direction. However, the embodiment of the inventive concept is not necessarily limited thereto. The exit angles C_{AG} and E_{AG} of the light emitted in FIGS. 7A and 7B respectively correspond to values with respect to a virtual reference line RL corresponding to the front direction.

For example, in the case of an embodiment including a light control portion having high refractive characteristics below the pattern layer, the emitted light may be prevented from diffusing in a lateral direction, thereby exhibiting a limited viewing angle range.

The display device of an embodiment includes a lower light control layer in a light control module and may thus exhibit high frontal luminance and limited side viewing angle. For example, in an embodiment, the frontal luminance may be 80% or greater, and the viewing angle range of the diffused light may be 3° from the front.

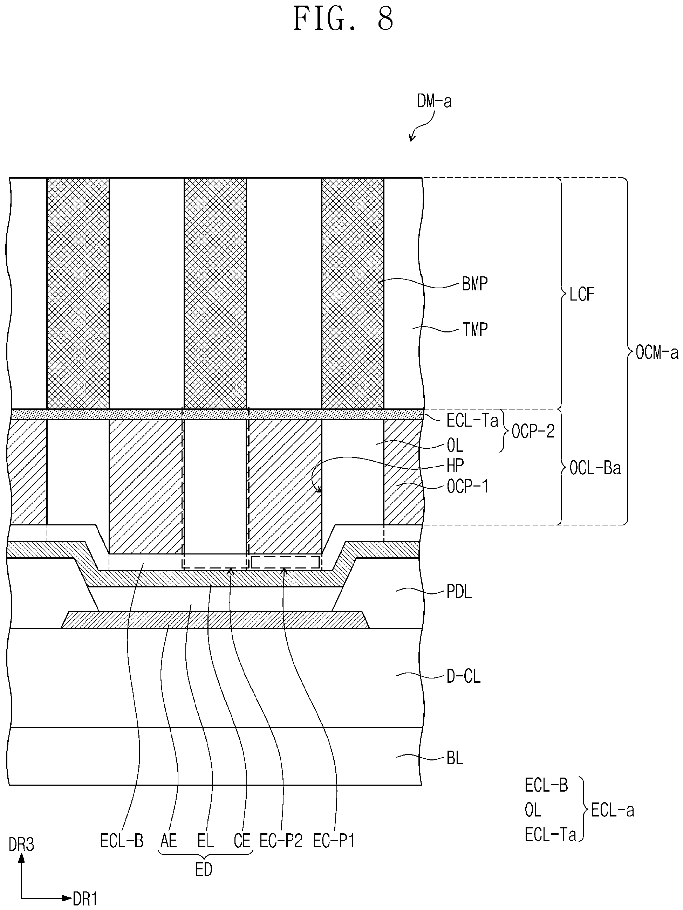

FIG. 8 is a cross-sectional view showing a portion of a display module DM-a according to an embodiment. FIG. 8 may correspond to portion AA of FIG. 4. The embodiment shown in FIG. 8 is different only in an encapsulation layer ECL-a from the embodiment shown in FIG. 5. In the display module DM-a according to the embodiment shown in FIG. 8, an upper inorganic flim ECL-Ta of the encapsulation layer ECL-a may also be disposed on a first portion OCP-1. The upper inorganic film ECL-Ta may extend from an upper portion of an organic film OL to an upper portion of the first portion OCP-1. In an embodiment, the upper inorganic film ECL-Ta may entirely overlap the first portion OCP-1 and the organic film OL and be provided as a single body. For example, a light control module OCM-a according to an embodiment may further include an upper inorganic film ECL-Ta disposed between the light control portion and the transmission portion TMP of the pattern layer LCF. In an embodiment shown in FIG. 8, light incident at an inclination angle from the first portion OCP-1 toward the transmission portion TMP may be controlled to be redirected so as not to be reflected from the light blocking portion BMP.

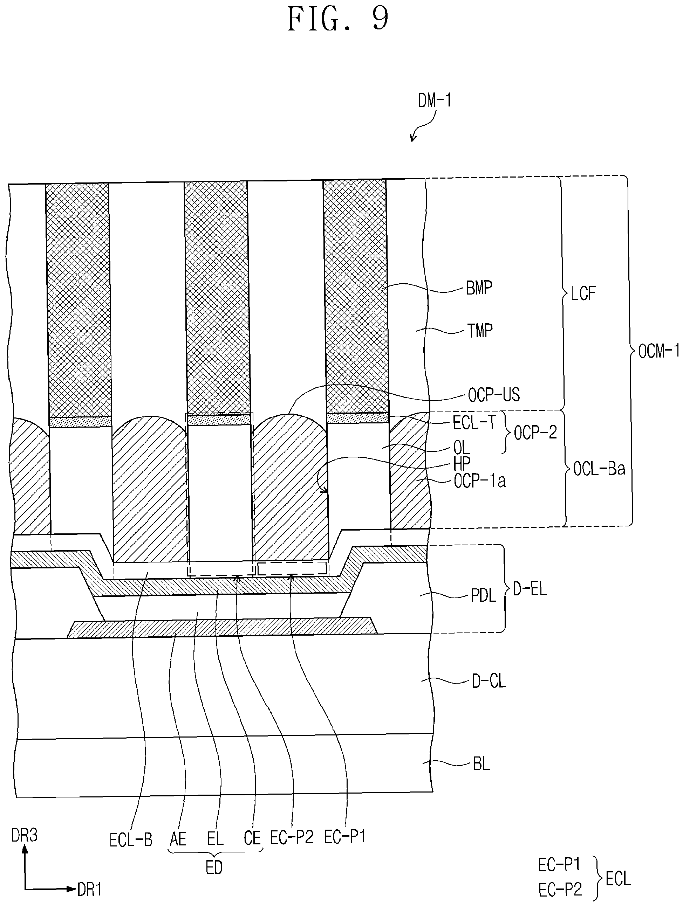

FIG. 9 is a cross-sectional view showing a portion of a display module according to an embodiment. A display module DM-1, according to an embodiment shown in FIG. 9, is different only in the composition of a lower light control layer OCL-Ba from the display module DM, according to an embodiment described with reference to FIGS. 4 and 5. In the description of the display module DM-1, according to an embodiment with reference to FIG. 9, to the extent that an element is not described in detail with respect to this figure, it may be understood that the element is at least similar to a corresponding element that has been described elsewhere within the present disclosure, such as with respect to FIGS. 1-8.

The display module DM-1, according to an embodiment, includes a light control module OCM-1 disposed on the display layer D-EL. The light control module OCM-1 includes a pattern layer LCF and a lower light control layer OCL-Ba disposed below the pattern layer LCF. The lower light control layer OCL-Ba includes a first portion OCP-1a and a second portion OCP-2, which are arranged alternately and repeatedly in one direction. The transmission portion TMP and the light blocking portion BMP of the pattern layer LCF may be alternately arranged in one direction. The first portion OCP-1a may overlap the transmission portion TMP, and the second portion OCP-2 may overlap the light blocking portion BMP.

In FIG. 9, the transmission portion TMP and the light blocking portion BMP are shown to be alternately and repeatedly arranged in the first direction DR1, but the embodiment of the inventive concept is not necessarily limited thereto, and the arrangement direction of the transmission portion TMP and the light blocking portion BMP may vary depending on the viewing angle limitation characteristics required for a display device.

The first portion OCP-1a of the lower light control layer OCL-Ba may have an upper surface OCP-US having a convex curved surface with respect to the transmission portion TMP. For example, a border between the first portion OCP-1a of the lower light control layer OCL-Ba and the transmission portion TMP of the pattern layer LCF may be curved according to the shape of the upper surface OCP-US of the first portion OCP-1a.

As used herein, the phrase "convex with respect to a direction or portion" means that the element is convex and bows in that direction or towards that portion.

The first portion OCP-1a may be disposed in the groove HP defined by the first encapsulation portion EC-P1 and the second encapsulation portion EC-P2 of the encapsulation layer ECL. The first encapsulation portion EC-P1 may be a portion including the lower inorganic film ECL-B, and the second encapsulation portion EC-P2 may be a portion including the lower inorganic film ECL-B, the organic film OL, and the upper inorganic film ECL-T. For example, the encapsulation layer ECL may include the lower inorganic film ECL-B disposed on the display layer D-EL, the organic film OL disposed on the lower inorganic film ECL-B, and the upper inorganic film ECL-T disposed on the organic film OL. In an embodiment, the organic film OL and the upper inorganic film ECL-T may be removed from a portion overlapping the transmission portion TMP to define the groove HP. In an embodiment, the upper inorganic film ECL-T of the encapsulation layer ECL might not be provided.

The second portion OCP-2 of the lower light control layer OCL-Ba is alternately arranged with the first portion OCP-1a, and in an embodiment, the second portion OCP-2 may be a portion including the organic film OL of the encapsulation layer ECL. In addition, in an embodiment, the second portion OCP-2 may include the organic film OL and the upper inorganic film ECL-T of the encapsulation layer ECL.

The first portion OCP-1a may be a portion having a greater level of liquid repellent properties as compared to the second portion OCP-2. As used herein, this may mean that the first portion OCP-1a may be more repellent of liquid than the second portion OCP-2. The first portion OCP-1a may be formed through polymerization from organic monomers having a liquid repellent functional group. The first portion OCP-1a may be a low molecule organic layer having a liquid repellent functional group. For example, the liquid repellent functional group may include fluorine (F). In addition, in an embodiment, the first portion OCP-1a may include an organic polymer and an additive having liquid repellent properties. The additive having liquid repellent properties may include fluorine (F).

The light control module OCM-1, according to an embodiment, includes a lower light control layer OCL-Ba including a first portion OCP-1a that overlaps the transmission portion TMP of the pattern layer LCF and has a convex upper surface with respect to the transmission portion TMP, and may thus exhibit limited light extraction in one direction. The first portion OCP-1a overlapping the transmission portion TMP and having greater liquid repellent properties than the second portion OCP-2, thereby having a convex upper surface, and accordingly, an incidence angle of light incident from the first portion OCP-1a to the transmission portion TMP may be regulated. For example, when light is incident from the first portion OCP-1a to the transmission portion TMP by the first portion OCP-1 having a convex curved upper surface OCP-US with respect to the transmission portion TMP, the light refracted and directed to the light blocking portion BMP may be minimized. Accordingly, a phenomenon of light diffusing when reflected and emitted from the side of the light blocking portion BMP may be minimized.

In an embodiment shown in FIG. 9 and the like, the lower light control layer OCL-Ba including the first portion OCP-1a whose interface with the transmission portion TMP has a convex curved shape is included, and thus light generated in the display layer D-EL and extracted toward the outside may be prevented from spreading widely. Accordingly, the display device of an embodiment may exhibit required limited viewing angle characteristics by limiting and controlling light emitted widely to the sides and also exhibit excellent front luminance characteristics. For example, in an embodiment, the frontal luminance may be 80% or greater, and the viewing angle range of the diffused light may be 3° from the front. However, the embodiment of the inventive concept is not necessarily limited thereto.

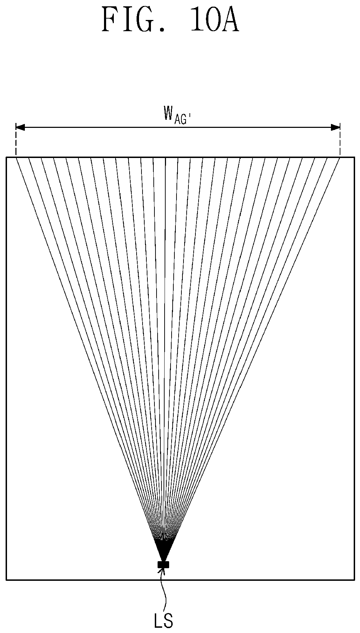

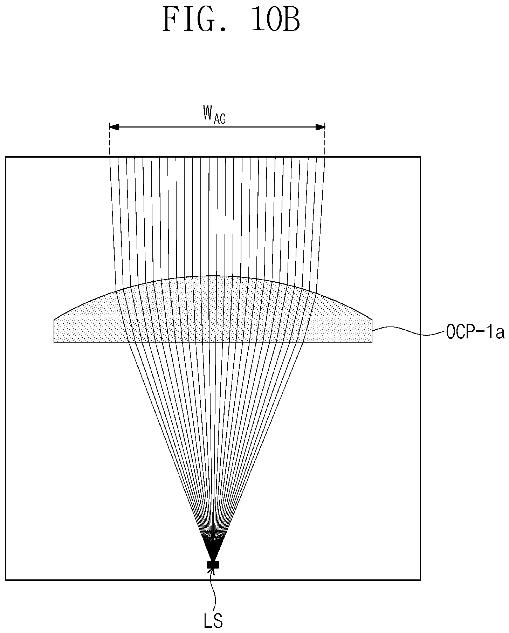

FIGS. 10A and 10B each show the results of light extraction simulation. FIG. 10A shows the results of light extraction simulation for Comparative Example, and FIG. 10B shows the results of light extraction simulation that illustratively reflects the shape of a light control module in the display device of an embodiment.

Example illustratively shown in FIG. 10B is different from Comparative Example illustratively evaluated and shown in FIG. 10A in that a first portion OCP-1a having a convex upper surface is included.

Referring to FIGS. 10A and 10B, FIG. 10B having a structure including the first portion OCP-1a having convex upper surface shows the reduced light output range compared to FIG. 10A not including the composition of the first light control portion.

Light emitted from the light source LS and incident on the first portion OCP-1a may be redirected according to the shape of the upper surface of the first portion OCP-1a. Accordingly, in the light output range of light emitted from the same light source LS, the light output range W_{AG} in FIG. 10B may be reduced as compared to the light output range W_{AG}' in FIG. 10A. For example, when referring to the simulation results shown in FIGS. 10A and 10B, it is seen that the case of an embodiment in which a light control portion whose interface with a transmission portion is not flat but is curved to allow a better collimation of light emitted after passing through the light control portion.

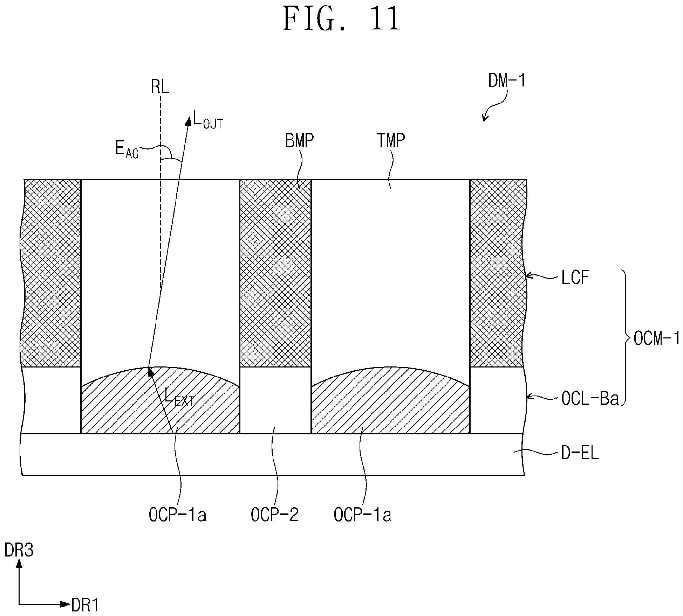

FIG. 11 is a view illustratively showing light extraction characteristics in the display module DM-1 according to an embodiment. A portion of the light emitted from the display layer D-EL and incident on the first portion OCP-1a of the lower light control layer OCL-Ba may be redirected at a border between the first portion OCP-1 and the transmission portion TMP, and accordingly, the phenomenon of light being reflected from the light blocking portion BMP may be reduced. For example, in the light emitted from the display layer D-EL, the light L_{EXT} incident on the lower light control layer OCL-Ba in the side direction instead of the front direction may be redirected in a stack structure of the first portion OCP-1a having a convex curved surface with respect to the transmission portion TMP and the transmission portion TMP disposed on the first portion OCP-1a. Accordingly, the light incident on the transmission portion TMP and directed to the light blocking portion BMP may be minimized, and an exit angle E_{AG} of the emitted light L_{OUT} may be smaller than an exit angle C_{AG} of the emitted light L_{OUT}' illustratively shown and described in FIG. 7A. For example, in an embodiment, the exit angle EAG of the emitted light L_{OUT} may be about 3° or less to one side in the front direction. However, the embodiment of the inventive concept is not necessarily limited thereto. The exit angle E_{AG} of the emitted light in FIG. 11 corresponds to a value with respect to a virtual reference line RL corresponding to the front direction.

For example, in the case of an embodiment including a light control portion having a curved upper surface below the pattern layer, the emitted light may be prevented from diffusing in a lateral direction, thereby exhibiting a limited viewing angle range.

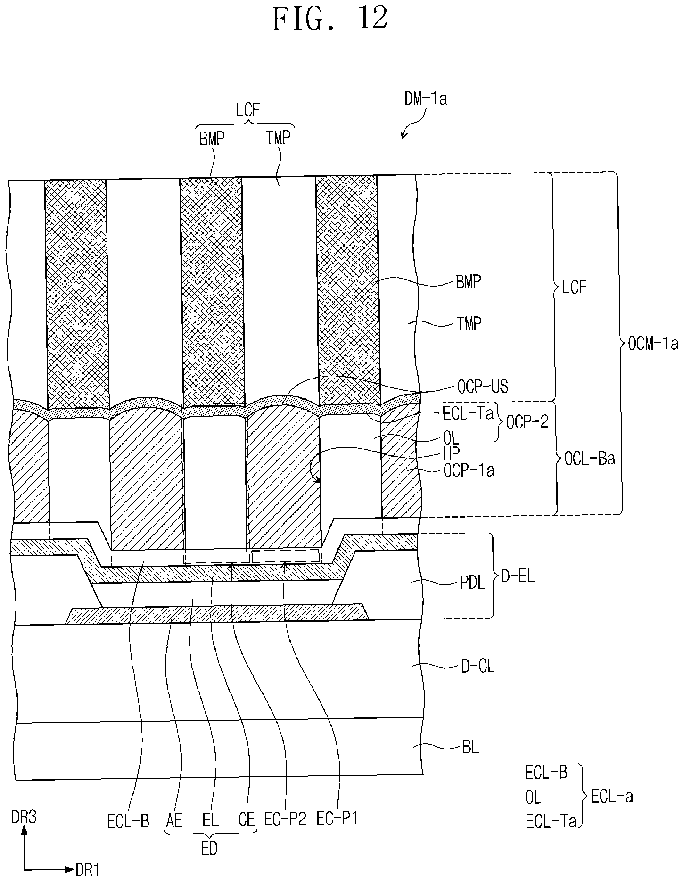

FIG. 12 is a cross-sectional view showing a portion of a display module DM-1a according to an embodiment. The embodiment shown in FIG. 12 is different only in an encapsulation layer ECL-a from the embodiment shown in FIG. 9. In the display module DM-1a according to the embodiment shown in FIG. 12, an upper inorganic film ECL-Ta of the encapsulation layer ECL-a may also be disposed on a first portion OCP-1a. The upper inorganic film ECL-Ta may extend from an upper portion of an organic film OL to an upper portion of the first portion OCP-1a. In an embodiment, the upper inorganic film ECL-Ta may entirely overlap the first portion OCP-1a and the organic film OL and be provided as a single body. For example, a light control module OCM-1a, according to an embodiment, may further include an upper inorganic film ECL-Ta disposed between the light control portion and the transmission portion TMP of the pattern layer LCF. In an embodiment shown in FIG. 12, light incident at an inclination angle from the first portion OCP-1a toward the transmission portion TMP may be controlled to be redirected so as not to be reflected from the light blocking portion BMP.

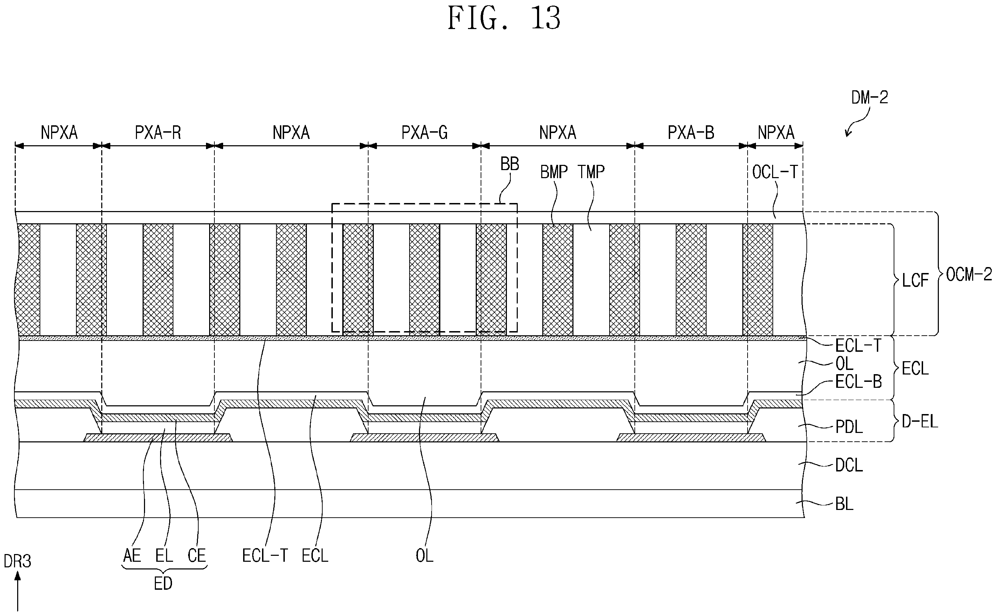

FIG. 13 is a cross-sectional view showing a portion of a display module according to an embodiment. A display module DM-2, according to an embodiment shown in FIG. 13, is different only in the composition of a light control module OCM-2 from the display module DM, according to an embodiment described with reference to FIG. 4 and the like. In the description of the display module DM-2, according to an embodiment with reference to FIG. 13, to the extent that an element is not described in detail with respect to this figure, it may be understood that the element is at least similar to a corresponding element that has been described elsewhere within the present disclosure, such as with respect to FIGS. 1-9.

In an embodiment, the light control module OCM-2 may include a pattern layer LCF and an upper light control layer OCL-T disposed on an upper portion of the pattern layer LCF. The pattern layer LCF may include the transmission portion TMP and the light blocking portion BMP repeatedly disposed in one direction. The display module DM-2 may include an encapsulation layer ECL disposed between the display layer D-EL and the pattern layer LCF. The encapsulation layer ECL may include a lower inorganic film ECL-B, an organic film OL, and an upper inorganic film ECL-T. In an embodiment, the upper light control layer OCL-T may include a plurality of protrusions that protrude in a direction away from the pattern layer LCF. Each of the plurality of protrusions of may have a prism shape or a lens shape.

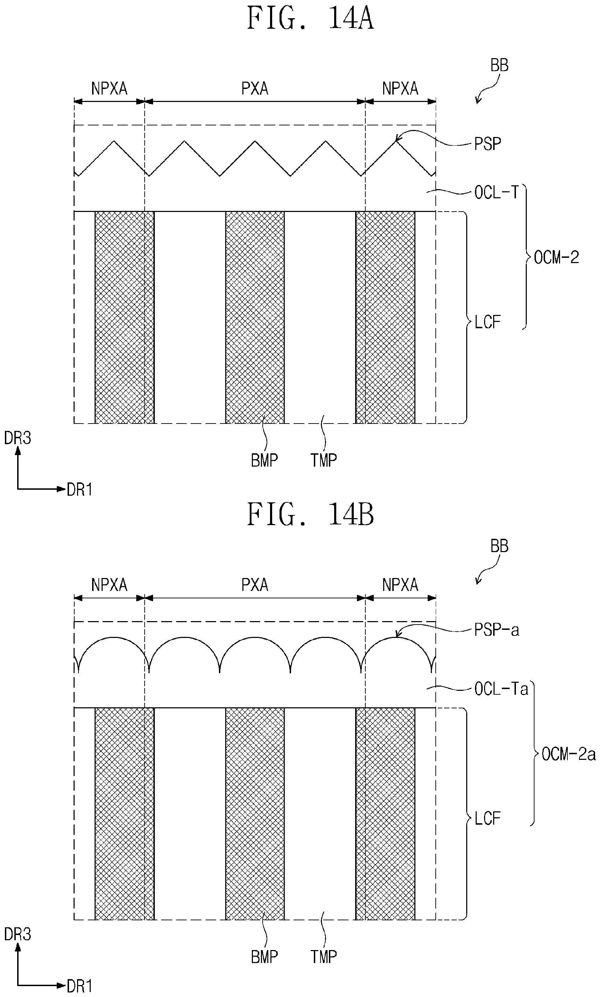

FIGS. 14A to 14C are each cross-sectional views showing a portion of a light control module according to an embodiment. FIGS. 14A to 14C may each be a view enlarging region BB of FIG. 13. FIGS. 14A to 14C illustratively show a light control module including an upper light control layer having various shapes of protrusions.

Referring to FIG. 14A, the light control module OCM-2, according to an embodiment, may include an upper light control layer OCL-T disposed on the pattern layer LCF, and the upper light control layer OCL-T may include a protrusion PSP protruding in a direction away from the pattern layer LCF. An upper portion of the protrusion PSP may have a triangular shape when viewed on a plane defined by the first direction DR1 and the third direction DR3. A plurality of protrusions PSP may be disposed in one light emitting region PXA. The protrusions PSP may serve to concentrate light provided through the pattern layer LCF.

In an embodiment shown in FIG. 14B, a light control module OCM-2a, according to an embodiment, may include an upper light control layer OCL-Ta disposed on the pattern layer LCF, and the upper light control layer OCL-Ta may include a protrusion PSP-a protruding in a direction away from the pattern layer LCF. An upper portion of the protrusions PSP-a may have a lens shape that is convex upwards when viewed on a plane defined by the first direction DR1 and the third direction DR3. A plurality of protrusions PSP-a may be disposed in one light emitting region PXA. The protrusions PSP-a may serve to concentrate light provided through the pattern layer LCF.

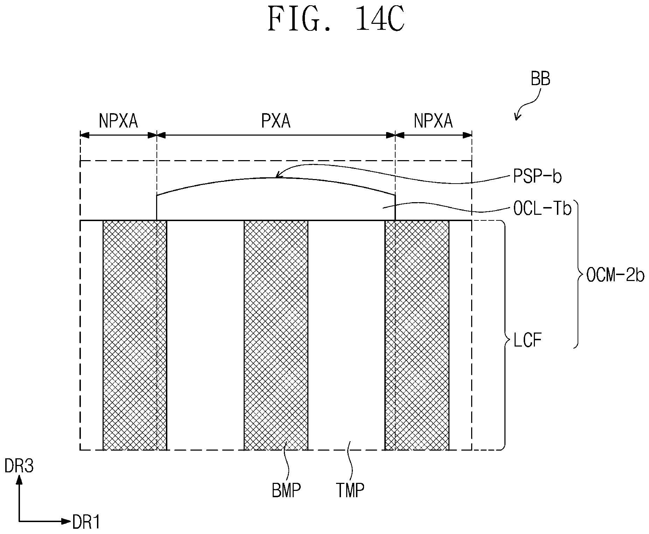

Referring to FIG. 14C, an upper light control layer OCL-Tb included in a light control module OCM-2b, according to an embodiment, may include a protrusion PSP-b having a lens shape convex in a direction away from the pattern layer LCF. In an embodiment, one protrusion PSP-b may correspond to one light emitting region PXA. In FIG. 14C, the upper light control layer OCL-Tb having the protrusion PSP-b is shown as disposed only in the light emitting region PXA, but the embodiment of the inventive concept is not necessarily limited thereto, and the upper light control layer OCL-Tb may also be further disposed in the peripheral region NPXA. The upper light control layer OCL-Tb disposed corresponding to the peripheral region NPXA may have a lens-shaped upper surface or a flat upper surface.

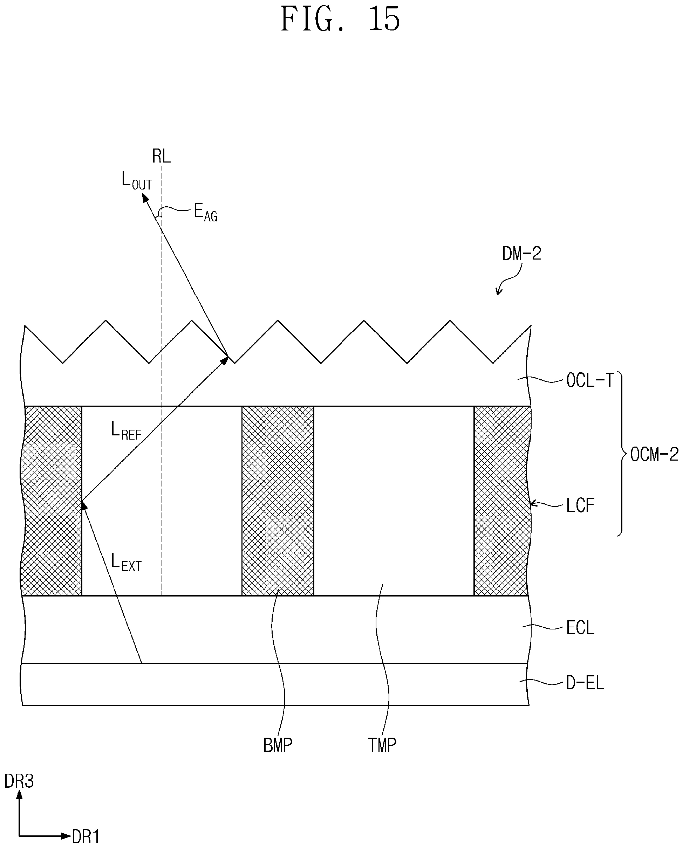

FIG. 15 illustratively shows the display module DM-2 according to an embodiment, and this shows light extraction characteristics when the light control module OCM-2 including the pattern layer LCF and the upper light control layer OCL-T is disposed on the display layer D-EL. A portion of light L_{EXT} emitted from the display layer D-EL and incident on the transmission portion TMP of the pattern layer LCF may be directed to the light blocking portion BMP. In the light blocking portion BMP, light may be partly absorbed and may be partly reflected. Light L_{REF} reflected from the light blocking portion BMP is incident on the upper light control layer OCL-T, and may be redirected by the upper portion shape of the upper light control layer OCL-T. Accordingly, an exit angle E_{AG} of light L_{OUT} incident on the transmission portion TMP, reflected from the light blocking portion BMP, and then emitted through the upper light control layer OCL-T may be smaller than an exit angle C_{AG} of light L_{OUT}' illustratively shown and described in FIG. 7A. For example, in an embodiment, the exit angle EAG of the emitted light L_{OUT} may be about 3° or less to one side in the front direction. However, the embodiment of the inventive concept is not necessarily limited thereto. The exit angle E_{AG} of the emitted light in FIG. 15 corresponds to a value with respect to a virtual reference line RL corresponding to the front direction.

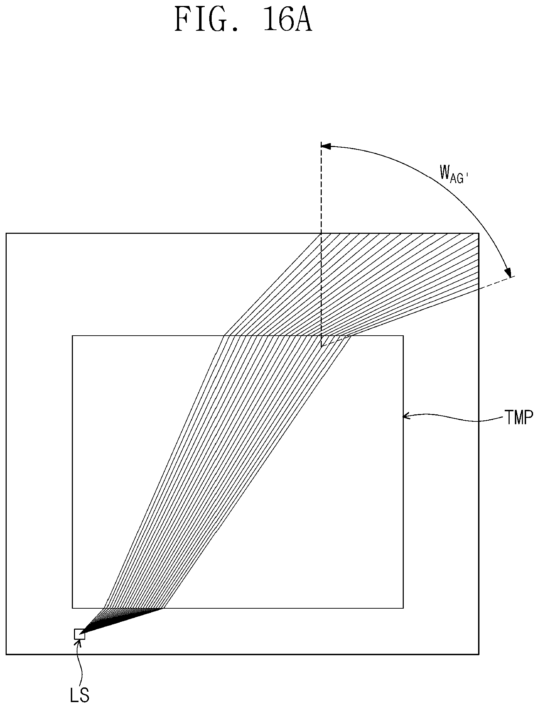

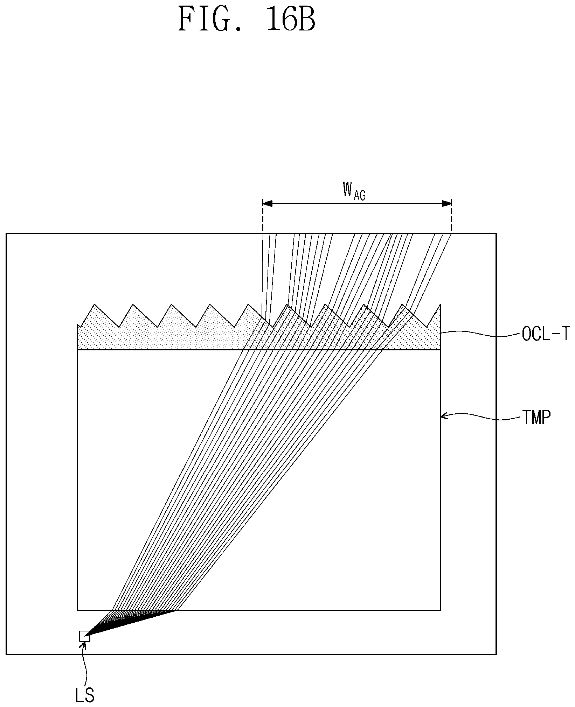

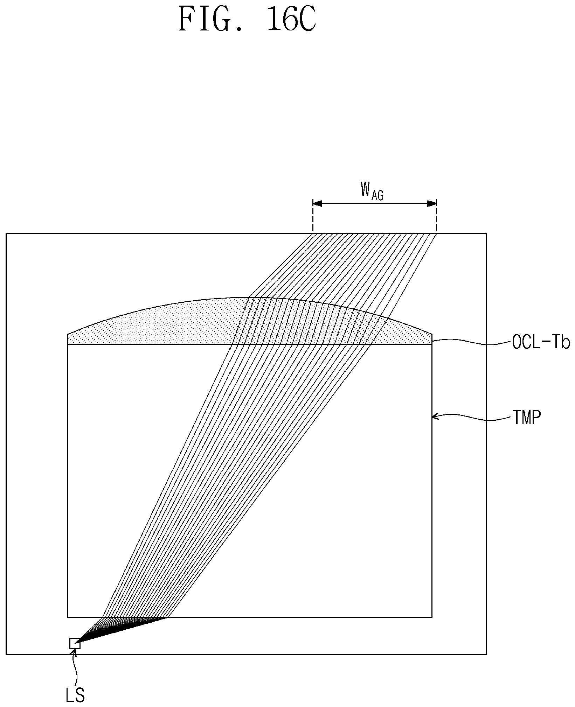

FIGS. 16A to 16C each show the results of light extraction simulation. FIG. 16A shows the results of light extraction simulation for Comparative Example, and FIGS. 16B and 16C each show the results of light extraction simulation that illustratively reflects the optical characteristics of a light control module in the display device of an embodiment. FIGS. 16A to 16C all show light output characteristics of light emitted from the same light source LS.

Compared to Comparative Example of FIG. 16A that includes no upper light control layer on the transmission portion TMP, FIGS. 16B and 16C show light output characteristics when the upper light control layers OCL-T and OCL-Tb are disposed on the transmission portion TMP. FIG. 16B shows light output characteristics when including the upper light control layer OCL-T having the shape of the protrusion PSP shown in FIG. 14A, and FIG. 16C shows light output characteristics when including the upper light control layer OCL-Tb having the shape of the protrusion PSP-b shown in FIG. 14C.

Referring to FIGS. 16A to 16C, the embodiment of FIGS. 16B and 16C, which has a structure including the upper light control layers OCL-T and OCL-Tb including protrusions protruding in a direction away from a pattern layer above the transmission portion TMP of the pattern layer shows reduced light output range compared to FIG. 16A including no upper light control layer.

Light emitted from the light source LS and incident on the transmission portion TMP may be redirected according to the upper surface shape of the upper light control layers OCL-T and OCL-Tb disposed on the transmission portion TMP. Accordingly, in the light output range of light emitted from the same light source LS, the light output range W_{AG} in FIGS. 16B and 16C may be reduced as compared to the light output range W_{AG}' in FIG. 16A. For example, when referring to the simulation results shown in FIGS. 16A to 16C, it is seen that the light output characteristics may be changed according to the shape of a surface from which light is emitted, and when an upper light control layer including convex protrusions with respect to a direction away from a pattern layer is included, the emitted light is more concentrated to allow a better light collimation in the front direction.

The display module, according to an embodiment shown in FIG. 13, includes the upper light control layer OCL-T disposed on the pattern layer LCF including the transmission portion TMP and the light blocking portion BMP, and including a plurality of protrusions having a convex shape in a direction away from the pattern layer LCF, and accordingly, light generated in the display layer D-EL and extracted toward the outside may be prevented from spreading widely. Accordingly, the display device of an embodiment may exhibit required limited viewing angle characteristics by limiting and controlling light emitted widely to the sides and also exhibit excellent front luminance characteristics. For example, in an embodiment, the frontal luminance may be 80% or greater, and the viewing angle range of the diffused light may be 3° from the front. However, the embodiment of the inventive concept is not necessarily limited thereto, and the viewing angle range may be regulated in consideration of viewing angle limitation characteristics required for a display device.

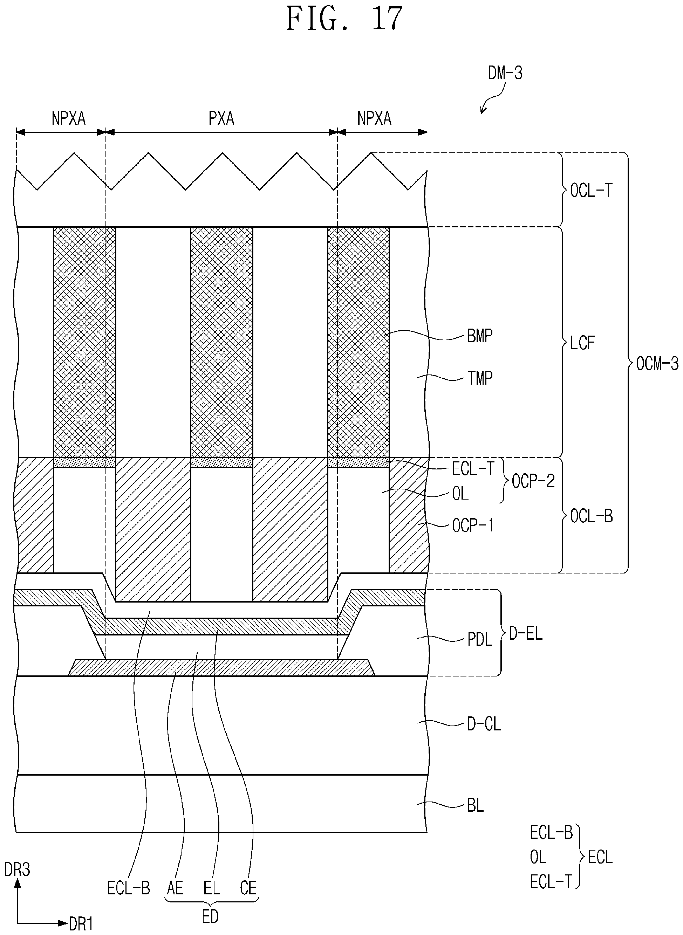

FIG. 17 is a cross-sectional view showing a portion of a display module according to an embodiment. A display module DM-3, according to an embodiment, shown in FIG. 17 is different only in the composition of a lower light control module OCM-3 from the display module DM, according to an embodiment described with reference to FIGS. 4 to 16C. In the description of the display module DM-3, according to an embodiment, with reference to FIG. 17, to the extent that an element is not described in detail with respect to this figure, it may be understood that the element is at least similar to a corresponding element that has been described elsewhere within the present disclosure, for example, in FIGS. 1 to 16C.

The display module DM-3, according to an embodiment, includes a light control module OCM-3 disposed on the display layer D-EL. The light control module OCM-3 includes a pattern layer LCF, a lower light control layer OCL-B disposed below the pattern layer LCF, and an upper light control layer OCL-T disposed on an upper portion of the pattern layer LCF. The lower light control layer OCL-B includes a first portion OCP OCP-1 and a second portion OCP-2, which are arranged alternately and repeatedly in one direction. The transmission portion TMP and the light blocking portion BMP of the pattern layer LCF may be alternately arranged in one direction. The first portion OCP-1 may overlap the transmission portion TMP, and the second portion OCP-2 may overlap the light blocking portion BMP.

In FIG. 17, the transmission portion TMP and the light blocking portion BMP are shown to be alternately and repeatedly arranged in the first direction DR1, but the embodiment of the inventive concept is not necessarily limited thereto, and the arrangement direction of the transmission portion TMP and the light blocking portion BMP may vary depending on the viewing angle limitation characteristics required for a display device.

In FIG. 17, the light control module OCM-3 may include both an upper light control layer OCL-T and a lower light control layer OCL-B. In the embodiment shown in FIG. 17, the light control module OCM-3 is shown to include a lower light control layer OCL-B, according to an embodiment shown in FIG. 5, and an upper light control layer OCL-T, according to an embodiment shown in FIG. 14A. However, this is presented as an example, and when the light control module OCM-3 includes both an upper light control layer and a lower light control layer, in the upper light control layer, the structure of an embodiment shown in FIG. 14B or FIG. 14C, or any other composition of the upper light control layer including a convex protrusion may be applied without limitation. In addition, the light control module OCM-3 may include the structure of the lower light control layer OCL-Ba described with reference to FIG. 9 and the like for the lower light control layer.

The display module, according to an embodiment shown in FIG. 17, includes the pattern layer LCF including the transmission portion TMP and the light blocking portion BMP, the lower light control layer OCL-B disposed below the pattern layer LCF and including a light control portion in a portion overlapping the transmission portion TMP, and the upper light control layer OCL-T disposed above the pattern layer LCF and including a plurality of convex protrusions with respect to a direction away from the pattern layer LCF, and accordingly, light generated in the display layer D-EL and extracted toward the outside may be prevented from spreading widely. Accordingly, the display device of an embodiment may exhibit required limited viewing angle characteristics by limiting and controlling light emitted widely to the sides and also exhibit excellent front luminance characteristics. For example, in an embodiment, the frontal luminance may be 80% or greater, and the viewing angle range of the diffused light may be 3° from the front. However, the embodiment of the inventive concept is not necessarily limited thereto, and the viewing angle range may be regulated in consideration of viewing angle limitation characteristics required for a display device.

The display device of an embodiment includes a pattern layer including transmission portions and light blocking portions alternately arranged in one direction, and accordingly, the direction light travels may be controlled in one direction. In addition, the display device of an embodiment includes a light control layer disposed on the upper portion and/or the lower portion of the pattern layer to control the viewing angle direction of light extracted outside the display device, thereby allowing a better collimation of light, and accordingly, excellent luminance characteristics and reduced light extraction at a side viewing angle may be achieved. The display device of an embodiment includes both a pattern layer and a light control layer, and may thus prevent images displayed on the display device from being viewed in a specified side viewing angle direction.

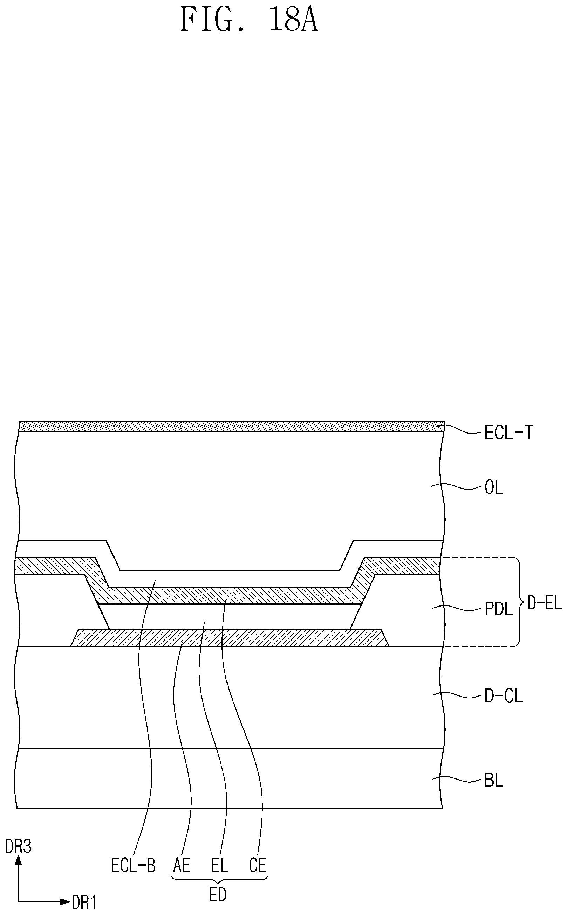

Hereinafter, a method for manufacturing a display device of an embodiment will be described with reference to FIGS. 18A to 19B and the like. FIGS. 18A to 19B are views showing some of the steps in a method for manufacturing a display device according to an embodiment. In describing FIGS. 18A to 19B, to the extent that an element is not described in detail with respect to this figure, it may be understood that the element is at least similar to a corresponding element that has been described elsewhere within the present disclosure, for example, with respect to FIGS. 1 to 17.

FIGS. 18A to 18E show a step in a method for manufacturing a display device including a display module according to an embodiment described with reference to FIGS. 4 and 5 as an example. FIGS. 18A to 18E show providing a light control module OCM including a lower light control layer OCL-B according to an embodiment as an example.

Referring to FIG. 18A, a circuit element layer D-CL and a display layer D-EL may be sequentially formed on a base layer BL. A lower inorganic film ECL-B, an organic film OL, and an upper inorganic film ECL-T may be sequentially provided on a display layer D-EL. The lower inorganic film ECL-B may be disposed directly on the display layer D-EL.

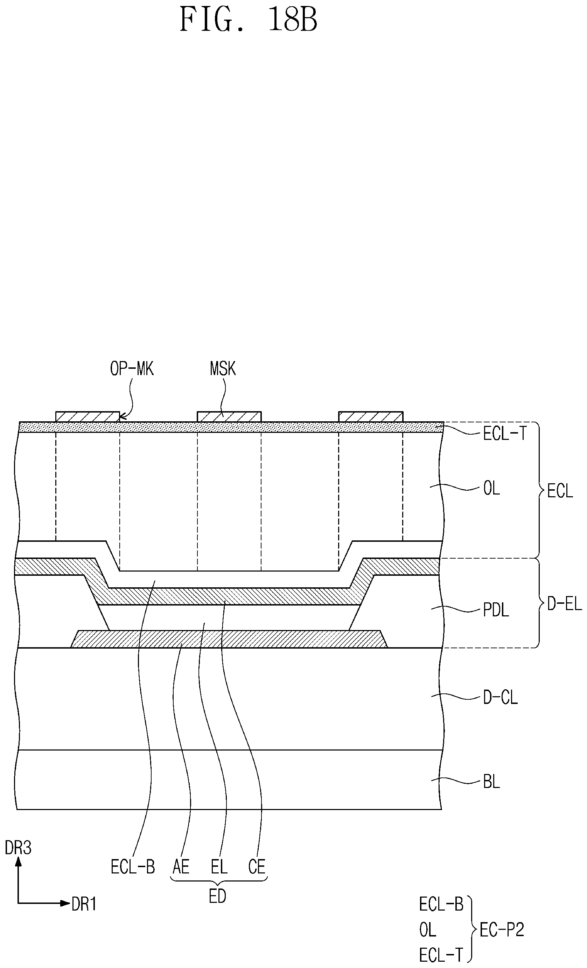

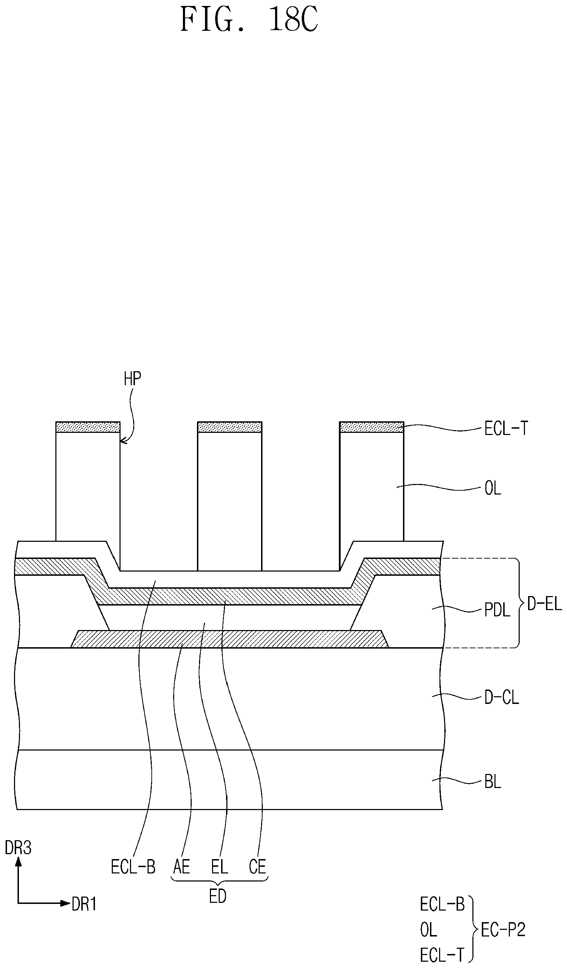

FIGS. 18B and 18C show patterning the organic film OL and the upper inorganic film ECL-T using a mask MSK to form an encapsulation layer ECL in which a groove HP is defined as an example. The organic film OL and the upper inorganic film ECL-T may be etched and removed in a transmission region OP-MK defined between the mask MSK. The groove HP may be defined between the stack structure of the organic film OL and the upper inorganic film ECL-T, and may be repeatedly defined in one direction.

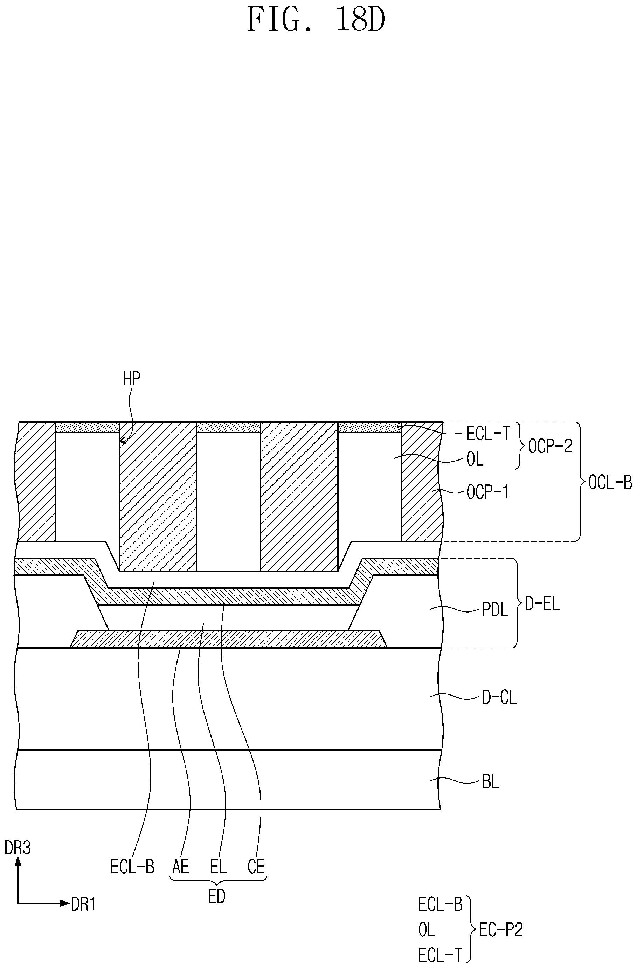

Referring to FIG. 18D, a first portion OCP-1 may be provided in the groove HP defined in the encapsulation layer. The first portion OCP-1 may have high refractive characteristics. The first portion OCP-1 may have a refractive index of greater than about 1.5. The first portion OCP-1 may have a greater refractive index than the organic film OL. An organic material having high refractive characteristics may be provided in the groove HP to form the first portion OCP-1. The organic material having high refractive characteristics may be provided to fill the groove HP using a method such as slit coating. The provided organic material may be formed into the first portion OCP-1 through polymerization and curing. Accordingly, a lower light control layer OCL-B including the first portion OCP-1 and the second portion OCP-2 may be formed in a step of the method manufacturing a display device, according to an embodiment. The second portion OCP-2 of the lower light control layer OCL-B may include the organic film OL. In addition, the second portion OCP-2 of the lower light control layer OCL-B may include the organic film OL and the upper inorganic film ECL-T. The first portion OCP-1 and the second portion OCP-2 of the lower light control layer OCL-B may be alternately and repeatedly arranged in one direction.

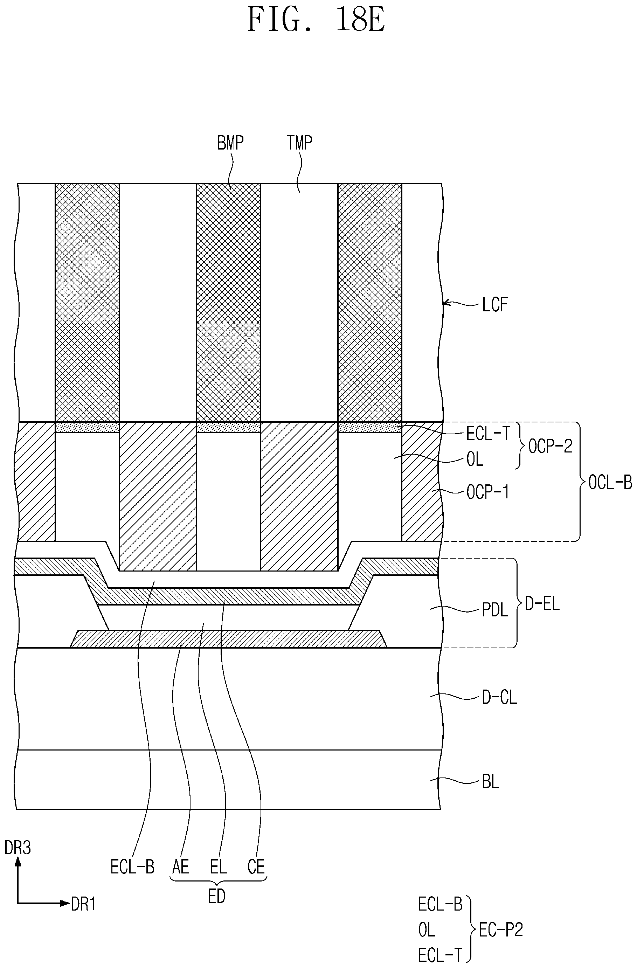

FIG. 18E shows providing a pattern layer LCF on the lower light control layer OCL-B. The pattern layer LCF may include a transmission portion TMP and a light blocking portion BMP, which are arranged alternately and repeatedly in one direction. The transmission portion TMP may overlap the first portion OCP-1, and the light blocking portion BMP may overlap the second portion OCP-2.

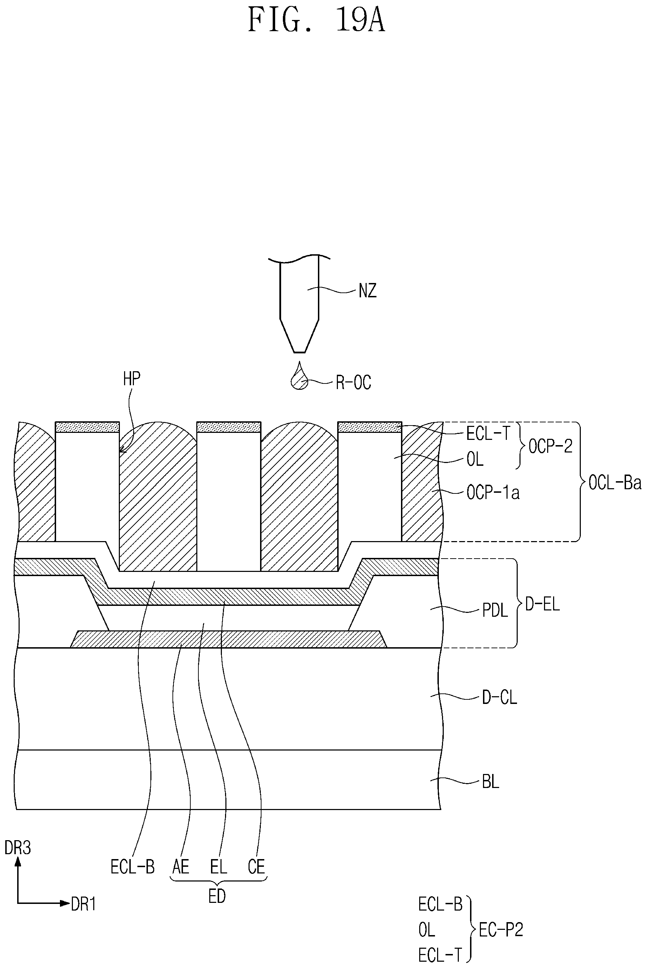

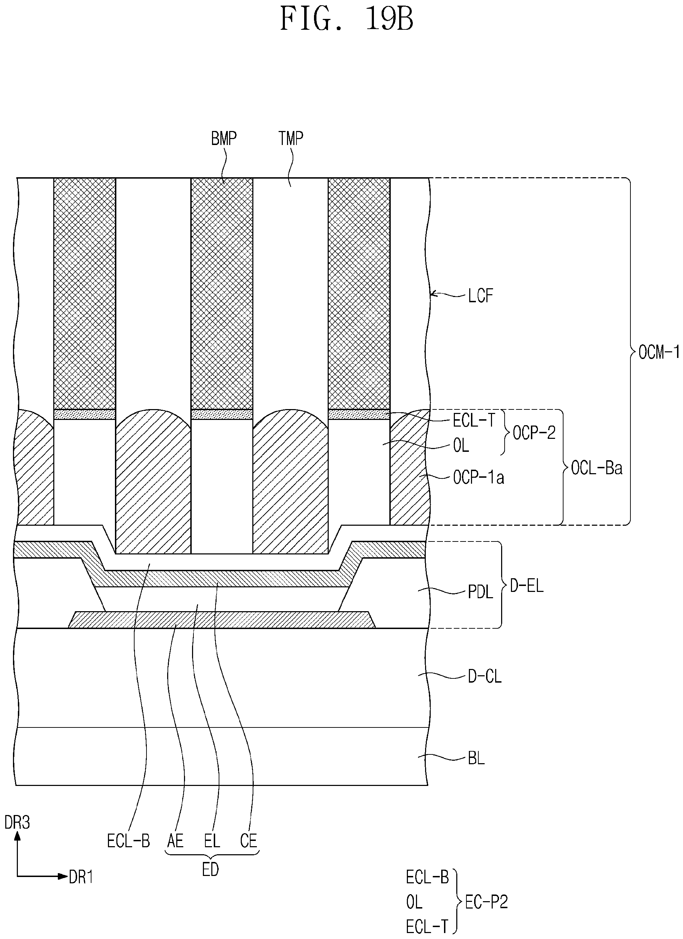

FIGS. 19A and 19B show a step in a method for manufacturing a display device including a display module according to an embodiment described with reference to FIG. 9 as an example. FIGS. 19A and 19B show providing a light control module OCM-1 including a lower light control layer OCL-Ba according to an embodiment as an example. FIG. 19A shows providing a first portion OCP-1a to the groove HP formed in the steps of FIGS. 18A to 18C described above.

Referring to FIG. 19A, the first portion OCP-1a may be provided in the groove HP defined in the encapsulation layer. The first portion OCP-1a may have liquid repellent properties. The first portion OCP-1a may be a portion having a greater level of liquid repellent properties as compared to the organic film OL. An organic material R-OC having liquid repellent properties may be provided in the groove HP to form the first portion OCP-1a. The organic material R-OC having liquid repellent properties may be provided through methods such as inkjet printing. The organic material R-OC having liquid repellent properties may be provided through a nozzle NZ to fill the groove HP. Due to the liquid repellent properties of the organic material R-OC, an upper surface of the organic material filling the groove HP may have a curved surface at a portion adjacent to the organic film OL and a portion spaced apart from the organic film OL. The upper surface of the organic material filled in the groove HP due to liquid repellent properties may form a convex curved surface. The organic material provided in the groove HP may be formed into the first portion OCP-1a through polymerization and curing. Accordingly, a lower light control layer OCL-Ba including the first portion OCP-1 and the second portion OCP-2 may be formed in a step of the method manufacturing a display device according to an embodiment. The second portion OCP-2 of the lower light control layer OCL-Ba may include the organic film OL. In addition, the second portion OCP-2 of the lower light control layer OCL-Ba may include the organic film OL and the upper inorganic film ECL-T. The first portion OCP-1a and the second portion OCP-2 of the lower light control layer OCL-B may be alternately and repeatedly arranged in one direction.

FIG. 19B shows providing a pattern layer LCF on the lower light control layer OCL-Ba. The pattern layer LCF may include a transmission portion TMP and a light blocking portion BMP, which are arranged alternately and repeatedly in one direction. The transmission portion TMP may overlap the first portion OCP-1a, and the light blocking portion BMP may overlap the second portion OCP-2.

FIGS. 18A to 19B show forming a light control module including a lower light control layer as an example. The display device of an embodiment may include an upper light control layer in the light control module, and in this case, the upper light control layer may be provided on an upper portion of the pattern layer after forming the pattern layer. In addition, when the light control module of the display device of an embodiment includes both a lower light control layer and an upper light control layer, providing an upper light control layer on the pattern layer may be further include in the forming of the light control module described with reference to FIGS. 18A to 19B.

The display device of an embodiment includes the pattern layer including a transmission portion and a light blocking portion alternately and repeatedly arranged in one direction, and the light control layer disposed on an upper portion and/or a lower portion of the pattern layer and controlling the direction of light output, and may thus minimize light viewable from the side direction or the up-down direction of the display device to exhibit limited viewing angle characteristics. In addition, the display device of an embodiment includes a light control layer that controls the direction of light output in the side direction or the up-down direction to allow a better collimation of light, and may thus exhibit excellent front luminance characteristics.

A display device of an embodiment may have controlled side viewing angle characteristics.

In addition, a display device of an embodiment may exhibit limited viewing angle characteristics and excellent front luminance characteristics.

Although the present disclosure has been described with reference to embodiments of the inventive concept, it will be understood that the inventive concept should not necessarily be limited to these embodiments but various changes and modifications may be made by those skilled in the art without departing from the scope of the present disclosure.

## Claims

1. A display device, comprising:
a display layer (D-EL) including a light emitting element; and
a light control module (OCM) disposed on the display layer,
wherein the light control module includes
a pattern layer (LCF) including a transmission portion (TMP) and a light blocking portion (BMP), the transmission portion (TMP) and the light blocking portion (BMP) being alternately arranged in a first direction (DR1) perpendicular to a thickness direction (DR3), and
a light control layer (OCL) overlapping the pattern layer in the thickness direction,
wherein the light control layer (OCL) includes at least one of:
a lower light control layer (OCL-B, OCL-Ba) disposed below the pattern layer and including a first portion overlapping the transmission portion, and a second portion overlapping the light blocking portion and including a material that is different from that of the first portion; and
an upper light control layer (OCL-T) disposed above the pattern layer and including a plurality of protrusions protruding in a direction away from the pattern layer.

2. The display device of claim 1, wherein the light control module (OCM) comprises the pattern layer (LCF) and the lower light control layer (OCL-B), and
wherein the first portion (OCP-1) of the lower light control layer (OCL-B) has a greater refractive index than each of the second portion and the transmission portion.

3. The display device of claim 1 or 2, wherein the first portion has a refractive index of 1.5 or more.

4. The display device of claim 1, wherein the light control module (OCM-1) comprises the pattern layer (LCF) and the lower light control layer (OCL-Ba), and
wherein an upper surface of the first portion (OCP-1a) adjacent to the pattern layer is a convex curved surface with respect to the transmission portion.

5. The display device of claim 4, wherein the first portion (OCP-1a) has a greater level of liquid repellent properties as compared to the second portion.

6. The display device of any of the preceding claims, further comprising an encapsulation layer (ECL) including a lower inorganic film disposed directly on the display layer.

7. The display device of claim 6, wherein the encapsulation layer (ECL) further comprises an upper inorganic film disposed between the pattern layer and the lower light control layer.

8. The display device of any of the preceding claims, wherein the light control module (OCM-2) comprises the pattern layer, and the upper light control layer (OCL-T) disposed directly on an upper portion of the pattern layer (LCF).

9. The display device of claim 8, wherein each of the protrusions of the upper light control layer (OCL-T) has a prism shape or a lens shape.

10. The display device of any of the preceding claims, wherein the light blocking portion (BMP) has an optical density of 1.5 to 2.0.

11. The display device of any of the preceding claims, wherein a first width of the transmission portion (TMP) in the first direction is greater than a second width of the light blocking portion (BMP) in the first direction.
